(19) **Europäisches Patentamt**

**European Patent Office**

**Office européen des brevets**

(11) **EP 0 564 709 B1**

(12) **EUROPÄISCHE PATENTSCHRIFT**

(45) Veröffentlichungstag und Bekanntmachung des Hinweises auf die Patenterteilung:
**24.01.1996 Patentblatt 1996/04**

(51) Int. Cl.$^6$: **C03C 17/34**, C23C 14/06, C23C 14/00, G02B 5/22

(21) Anmeldenummer: **92120619.9**

(22) Anmeldetag: **03.12.1992**

(54) **Beschichtetes transparentes Substrat, Verwendung hiervon, Verfahren und Anlage zur Herstellung der Schichten, und Hafnium-Oxinitrid (HfOxNy) mit 1,5 ≤ x/y ≤ 3 und 2,6 ≤ n ≤ 2,8**

Coated transparent substrate, use thereof, method and apparatus of manufacturing such coatings, and hafnium-oxynitride HfOxNy with 1.5 x/y 3 and 2.6 n 2.8

Substrat transparent revêtu, son emploi, procédé de fabrication des revêtements et dispositif pour la mise en oeuvre d'un tel procédé et oxynitrure d'hafnium

(84) Benannte Vertragsstaaten:
**CH DE FR GB IT LI**

(30) Priorität: **13.12.1991 CH 3700/91**

(43) Veröffentlichungstag der Anmeldung:
**13.10.1993 Patentblatt 1993/41**

(73) Patentinhaber: **BALZERS AKTIENGESELLSCHAFT FL-9496 Balzers (LI)**

(72) Erfinder:
• **Rudigier, Helmut, Dipl.-Physiker ETH CH-7310 Bad Ragaz (CH)**
• **Sperger, Reinhard, Dipl.-Ing. AT-6800 Feldkirch (AT)**

(74) Vertreter: **Troesch Scheidegger Werner AG CH-8050 Zürich (CH)**

(56) Entgegenhaltungen:
EP-A- 0 303 587          DE-A- 4 006 029
US-A- 4 947 081

• PATENT ABSTRACTS OF JAPAN vol. 9, no. 218 (C-301)(1941) 5. September 1985 & JP-A-60081048
• PATENT ABSTRACTS OF JAPAN vol. 15, no. 119 (P-1183)(4647) 22. April 1991 & JP-A-3008137
• PATENT ABSTRACTS OF JAPAN vol. 7, no. 3 (C-143)(1148) 7. Januar 1983 & JP-A-57161058

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die vorliegende Erfindung betrifft ein beschichtetes, transparentes Substrat gemäss Anspruch 1, dessen Verwendung gemäss Anspruch 29, ein Verfahren zur Herstellung der Oxinitridschicht nach dem Oberbegriff von Anspruch 30, weiter eine Anlage zur Ausführung des genannten Verfahrens nach dem Oberbegriff von Anspruch 35 und ein Hafnium-Oxinitrid als Schichtmaterial am genannten Substrat nach Anspruch 38.

Es sollen vorerst einige verwendete Grössen definiert werden.

Sichtbarer Lichtbereich:

Spektralbereich zwischen 380nm und 780nm,

Sonnenlicht:

Spektralbereich von 200nm bis 2500nm,

Nahes Infrarot:

Spektralbereich zwischen 780nm und 1200nm,

Reflexionskoeffizient $R_{vis}$:

mit der Spektrallichtempfindlichkeit des menschlichen Auges gewichtetes Verhältnis zwischen reflektiertem und einfallendem Licht:

$$R_{vis} = \frac{\int_{380nm}^{780nm} R(\lambda)V(\lambda)S(\lambda)d\lambda}{\int_{380nm}^{780nm} V(\lambda)S(\lambda)d\lambda}$$

worin bezeichnen:

$R(\lambda)$      Reflexionswert bei einer bestimmten Wellenlänge $\lambda$,

$V(\lambda)$      spektraler Hellempfindlichkeitswert des menschlichen Auges,

$S(\lambda)$      spektrale Strahlungsverteilung von Normlicht D65 (Farbtemperatur 6500K).

Transmissionskoeffizient $T_{vis}$:

-   mit der spektralen Lichtempfindlichkeit des menschlichen Auges gewichtetes Verhältnis zwischen transmittiertem und einfallendem Licht:

$$T_{vis} = \frac{\int_{380nm}^{780nm} T(\lambda)V(\lambda)S(\lambda)d\lambda}{\int_{380nm}^{780nm} V(\lambda)S(\lambda)d\lambda}$$

worin weiter bezeichnet:

$T(\lambda)$      Transmissionswert bei einer bestimmten Wellenlänge $\lambda$,

Transmissionskoeffizient $T_{SONNE}$:

-   mit der spektralen Strahlungsverteilung der Sonne gewichtetes Verhältnis zwischen transmittiertem Licht und einfallendem Licht:

$$T_{SONNE} = \frac{\int\limits_{200nm}^{2500nm} T(\lambda)S_s(\lambda)d\lambda}{\int\limits_{200nm}^{2500nm} S_s(\lambda)d\lambda}$$

worin bezeichnet:

$S_s(\lambda)$   spektrale Verteilung der Sonnenstrahlung.

Reflexionskoeffizient $R_{SONNE}$:

-   mit der spektralen Strahlungsverteilung der Sonne gewichtetes Verhältnis zwischen reflektiertem Licht und einfallendem Licht:

$$R_{SONNE} = \frac{\int\limits_{200nm}^{2500nm} R(\lambda)S_s(\lambda)d\lambda}{\int\limits_{200nm}^{2500nm} S_s(\lambda)d\lambda}$$

Absorption $A_{SONNE}$:

$$A_{SONNE} = \frac{\int\limits_{200nm}^{2500nm} A(\lambda)S_s(\lambda)d\lambda}{\int\limits_{200nm}^{2500nm} S_s(\lambda)d\lambda}$$

worin weiter:

$A(\lambda)$   der Absorptionswert bei einer bestimmten Wellenlänge $\lambda$ bedeutet.

Extinktionskonstante k:

-   Wenn Licht der Wellenlänge $\lambda$ und der Intensität $I_o$ durch Material der Dicke d transmittiert wird, ergibt sich ausgangsseitig die Intensität

$$I = I_o \cdot e^{-\alpha(\lambda) \cdot d}$$

Es gilt:    $k(\lambda) = \alpha \dfrac{\lambda}{4\pi}$

Es sind Vorschläge zur Realisierung von Wärmeschutzschichten bekannt, welche auf der Verwendung von reinen Metallschichten, z.B. Silberschichten, basieren oder metallischer Nitridschichten, wie von TiN-Schichten, welche eingebettet sind zwischen zwei Metalloxidschichten mit vorzugsweise hohem Brechungsindex.

Dabei ist es ebenso bekannt, dass Silberschichten chemisch nicht beständig sind und so z.B. während des Aufbringens der zweiten Oxidschicht oxidieren und damit ihre günstigen optischen Eigenschaften verlieren oder aber zur Bildung einzelner Silberinseln neigen.

Auch ist es oft schwierig, eine genügende Haftung zwischen der Silberschicht und den Oxidschichten zu gewährleisten, was die Verschleissanfälligkeit derartiger Schichtsysteme massiv negativ beeinflusst.

Es ist aus der DE-A-33 07 661 bekannt, unmittelbar auf die Silberschicht eine dünne metallische Schicht aufzubringen, um die erwähnte Inselbildung zu unterdrücken.

Aus der DE-A-33 29 504 ist es weiter bekannt, mittels gradueller Uebergänge zwischen oxidischen Schichten ($TiO_2$) und der Silberschicht eine erhöhte Haltbarkeit und Lebensdauer des Schichtsystems zu erzielen. Dabei ist weiterhin auszuführen, dass eine genügende Verbesserung der Verschleisseigenschaften wohl nicht erreicht wird und dass Reflexions- bzw. Transmissionsverhalten relativ schmalbandig sind, das Transmissionsverhalten weiter im sichtbaren Lichtbereich relativ schlecht ist.

Auf die Problematik der Dreilagenbeschichtung aus Titan, TiN und Titanoxid, vor allem in bezug auf hohe Reflexionsgrade, die Haftung derartiger Systeme sowie ihre Verschleissbeständigkeit ist in Silikattechnik 38 (1987), Heft 8, S.

281 bis 283, eingegangen. In Silikattechnik 39 (1988), Heft 9, S. 296 bis 300, werden die Nachteile von in Titandioxidschichten eingepackten Titannitrid- und Silberschichten diskutiert.

In der EP-A-0 334 991 wird ein $SnO_2/SnNi/SnO_2$-Schichtsystem mit einer suboxidischen SnNi-Schicht als Wärmeschutzschichtsysten vorgeschlagen. Es werden dabei relativ hohe Wärmetransmissionswerte erreicht, eine gute Transmission über 60% im sichtbaren Lichtbereich wird aber nur durch Tempern erbracht.

Im weiteren kann auch auf die EP-A-0 303 587 bezüglich Schichtsystemen mit Metallschichten verwiesen werden, hier um eine Enteisung elektrisch vornehmen zu können.

Bezüglich dielektrischer Schichtsysteme kann im weiteren auf die US-A-4 461 532 hingewiesen werden.

Im weiteren wird auch auf die DE-A-40 24 308 und die EP-A-0 402 075 bezüglich weiterer transparenter, beschichteter Substrate hingewiesen.

Aus Patent Abstracts of Japan, Vol. 9, no. 218 (C-301)(1941) 5. September 1985 & JP,A,60 081 048 (TOYOTA JIDOSHA KK) 9. Mai 1985, ist es bekannt, durch einen reaktiven Aetzprozess in einer Sauerstoffatmosphäre auf Glassubstrat eine Titanoxidschicht abzulegen und nach Unterbrechung der Sauerstoffzuführung und Aufnahme einer Stickstoffzuführung eine Titannitridschicht abzulegen. Dabei wird ein beschichtetes, transparentes Substrat mit einem mehrschichtigen Schichtsystem zu dekorativen Zwecken versehen, welches nicht transparent ist. Das Schichtsystem besteht im wesentlichen aus Titanoxid- und Titannitridschichten.

Aus der US-A-4 947 081 ist es weiter bekannt, eine Tantal-Oxinitridschicht als Diffusionsbarriere gegen Sauerstoff an einem Elektroluminiszenzelement vorzusehen.

Im weiteren ist es aus Patent Abstracts of Japan, Vol. 15, no. 119 (P-1183) (4647) 22. April 1991 & JP,A,3 008 137 (NEC CORP.) 16. Januar 1991, bekannt, an einem optischen Speicherelement eine Korrosionsschutzschicht aus einem Oxinitrid der Elemente Si, Ti, Zr, Hf, Al oder Ta vorzusehen.

Aus der DE-A-4 006 029, entsprechend der US-A-5 085 926, ist ein beschichtetes, transparentes Glassubstrat bekannt, worauf eine Sechslagenbeschichtung vorgesehen ist. Das so beschichtete Substrat findet beispielsweise Verwendung als Fahrzeugfensterglas. An der Sechslagenbeschichtung sind, ausgehend vom Glassubstrat, die zweite und vierte Schicht aus einem Nitrid oder Oxinitrid eines Metalles gebildet, ausgewählt aus der Gruppe Ti, Zr, Ta, Cr, Ni/Cr-Legierung oder Edelstahl, sind mit einer Dicke zwischen 3 und 20nm und bevorzugterweise dünner ausgebildet und dienen dazu, die Haftfähigkeit zwischen den angrenzenden ersten und dritten bzw. dritten und fünften Schicht zu erhöhen. Die sechste Schicht, als dicker als 30nm ausgebildete Verschleissschutzschicht besteht aus dem Oxid oder Oxinitrid einer Legierung, ausgewählt aus Si/Al-, Si/Ti- und Si/ni-Legierungen oder aus dem Nitrid oder Oxinitrid von Aluminium. Bevorzugterweise liegt dabei die Dicke der sechsten Lage als Verschleissschutzschicht zwischen 40 und 200nm.

Die vorliegende Erfindung stellt sich unter einem ersten Aspekt zur Aufgabe, ein beschichtetes, transparentes Substrat zu schaffen, welches

- eine tiefe Sonnenenergietransmission $T_{SONNE}$ aufweist,

- im sichtbaren Spektralbereich entspiegelt ist, mithin tiefe $R_{vis}$-Werte aufweist, und

- verschleissbeständig ist.

Dies wird an einem beschichteten, transparenten Substrat, ausgebildet nach dem Wortlaut von Anspruch 1, erreicht.

Es wurde gefunden, dass die genannten Oxinitride des Hafniums, Zirkons, Tantals oder Titans, insbesondere des Hafniums, einen hohen Brechungsindex aufweisen, im sichtbaren und nahen IR-Bereich, gleichzeitig im sichtbaren wie auch im nahen IR-Bereich sehr tiefe k-Werte. Dies ermöglicht, Schichtsysteme mit optimal wenig Schichten zu realisieren, die, da insbesondere das HfON, TaON und ZrON ausgesprochen verschleissbeständig sind, die gestellte Aufgabe kostengünstig und trotzdem optisch optimal lösen. Zur Sicherstellung insbesondere auch der Verschleissbeständigkeit wird das erfindungsgemässe Substrat nach dem Wortlaut von Anspruch 2 ausgebildet, dabei bevorzugterweise nach demjenigen von Anspruch 3.

Bei Vorgehen nach dem Wortlaut von Anspruch 4 wird von der Erkenntnis ausgegangen, dass, um der Problemstellung beidseitig des Substrates gerecht zu werden, beide Substratseiten mit einem Schichtsystem versehen werden müssen. Es wird auf der einen Seite des Substrates ein Schichtsystem aufgebracht, welches als Wärmeschutzsystem sowie als einseitiges Entspiegelungssystem wirkt; das auf der anderen Seite des Substrates vorgesehene Schichtsystem steigert die Wärmeschutzwirkung des ersterwähnten und wirkt seinerseits als Entspiegelungssystem.

Beim beidseitigen Vorsehen der Schichtsysteme wird aufgrund der guten Materialeigenschaften des Hafnium-, Zirkon-, Tantal- oder Titanoxinitrides, insbesondere derjenigen des Oxinitrides von Hafnium, die Wärmeschutzwirkung des Gesamtsystems wesentlich über diejenige je der Einzelsysteme angehoben.

Durch Ausbildung des Schichtsystems oder der Schichtsysteme als rein dielektrische Systeme, d.h. mit Schichten der erwähnten Oxinitride, eingebettet in Schichten eines niedriger brechenden, ebenfalls dielektrischen Materials, vor-zugsweise aus $SiO_2$, wird eine ausgeprägte Verbesserung des Reflexionsverhaltens im tiefen Infrarotbereich, mithin ein ausgezeichneter Wärmeschutz erzielt. Das gute Reflexionsverhalten im sichtbaren Bereich ergibt die ausgezeichnete Entspiegelungsmöglichkeit. Dies aufgrund des dank des Oxinitrides erwirkten steilen Reflexionsverlaufsanstieges im Uebergangsbereich vom sichtbaren Licht zum nahen (tiefen) Infrarot am Gesamtsystem. Beim Einsatz des Hafnium-Oxinitrides ist dies besonders ausgeprägt.

Wird bevorzugterweise auf einer der Substratseiten ein Schichtsystem nach dem Wortlaut von Anspruch 5, auf der anderen ein dielektrisches Schichtsystem, d.h. ohne Nitrid- bzw. Indium-Zinnoxidschicht (ITO), jedoch mit der wesentlichen Oxinitridschicht nach Anspruch 1 vorgesehen, so wird durch das System mit der Nitrid- bzw. ITO-Schicht eine Reflexion auch der höheren Wellenlängen im Infrarotbereich, ab 1200nm, erwirkt, zusätzlich zu der durch die Oxinitridschicht bewirkten, im tiefen Infrarotbereich zwischen 780nm und 1200nm.

Wieder sichert die bevorzugterweise beidseitig vorgesehene Oxinitridschicht, vorzugsweise Hafnium-Oxinitridschicht, dank der durch sie sich ergebenden steilen Reflexionskante im Uebergangsbereich, sichtbarer Bereich/naher IR-Bereich, eine hohe Reflexion der Wärmestrahlung und eine tiefe im sichtbaren Spektralbereich. Es bildet die erwähnte Oxinitridschicht, bevorzugterweise diejenige des Hafniums, Basis für die guten Wärmeschutz- und Entspiegelungseigenschaften und dafür, dass diese bei Vorsehen von optimal wenig Schichten erzielt werden.

Wird nun gemäss Wortlaut von Anspruch 6 am Schichtsystem gemäss Anspruch 5 die Nitridschicht aus derselben Metallkomponente aufgebaut wie die Oxinitridschicht und folgen sich diese Schichten, so wird nebst bevorzugten Eigenschaften, was die Forderungen gemäss Aufgabenstellung anbelangt, noch zusätzlich erreicht, dass eine höchst wirtschaftliche Herstellung ermöglicht ist, mithin das Gesamtsystem kostengünstig wird.

Dies, weil sich damit die Möglichkeit eröffnet, die Herstellung nach dem Wortlaut von Anspruch 33 bzw. 34 vorzunehmen.

Dies kann sogar dann erfolgen, wenn zwischen Nitrid- und Oxinitridschicht eine Schicht eines niedrig brechenden Materials, so beispielsweise von $SiO_2$, aufgebracht wird, indem beispielsweise von einem Hf-Tiegel-Betrieb zu einem Si-Tiegel-Betrieb und zurück zum Hf-Tiegel-Betrieb gewechselt wird und dabei ein Gaszuführungswechsel erfolgt. Es wird ohne Prozessunterbruch die angestrebte Schichtabfolge realisiert.

Es hat sich nun weiter gezeigt, dass durch Vorsehen der Oxinitridschicht als zweitäusserste Schicht nach dem Wortlaut von Anspruch 8 des Schichtsystems oder der Schichtsysteme der Verschleisswiderstand der jeweiligen Systeme über denjenigen von Gläsern angehoben bleibt. M.a.W. weist das erwähnte Oxinitrid, insbesondere dasjenige von Hafnium, zusätzlich zu seinen unerwarteten optischen Eigenschaften auch eine Verschleissfestigkeit auf, die im Vergleich mit anderen optischen Schichten, beispielsweise Nitridschichten, ebenso gut ist und eine Verschleissfestigkeit ergibt, die über derjenigen üblicher Substratmaterialien, beispielsweise von Glas, liegt.

Dem Wortlaut von Anspruch 9 folgend, weist bevorzugterweise das erfindungsgemässe, doppelseitig beschichtete Substrat mindestens in wesentlichen Spektralbereichen des sichtbaren Bereiches die im angegebenen Anspruch aufgeführten Werte auf.

Im weiteren ist vorzugsweise die Reflexion, dem Wortlaut von Anspruch 10 folgend, mindestens in wesentlichen Teilen des sichtbaren Spektralbereiches bis zu Einfallswinkeln von mindestens 60°, vorzugsweise von mindestens 65°, geringer als diejenige des nicht beschichteten Substrates.

Dem Wortlaut von Anspruch 11 folgend, weist das erfindungsgemässe, beschichtete, transparente Substrat, mindestens einseitig, im Spektralbereich von 520nm bis 620nm eine Reflexion von höchstens 18%, vorzugsweise von höchstens 15%, auf, dies bevorzugterweise bis zu Einfallswinkeln von mindestens 60°, vorzugsweise von mindestens 65°.

Dem Wortlaut von Anspruch 12 folgend, weist das bevorzugterweise doppelseitig beschichtete Substrat mindestens im Spektralbereich von 450nm bis 600nm eine Transmission von mindestens 70% auf, vorzugsweise von mindestens 75%.

Dem Wortlaut von Anspruch 13 folgend, beträgt der Brechungsindex des Oxinitrides mindestens einer der Oxinitridschichten 2,5 bis 3, bevorzugterweise 2,6 bis 2,8, für Licht von 400nm, wobei gleichzeitig die Extinktionskonstante k höchstens 0,02, vorzugsweise höchstens 0,01, beträgt.

In Anspruch 15 ist eine heute bevorzugte Ausbildung des mindestens einen Schichtsystems spezifiziert.

Ein weiterer, heute bevorzugter Aufbau des oder der am erfindungsgemässen Substrat vorgesehenen Schichtsysteme ist in Anspruch 16 spezifiziert. Dabei bilden bevorzugterweise die erwähnten weiteren Schichten ein Schichtsystem, wie es in Anspruch 1 spezifiziert ist, dies gemäss Anspruch 17.

In einer weiteren Ausführungsvariante der Erfindung ist das mindestens eine am erfindungsgemässen Substrat vorgesehene Schichtsystem nach dem Wortlaut von Anspruch 18 aufgebaut, wobei die darin erwähnten weiteren Schichten bevorzugterweise, und dem Wortlaut von Anspruch 19 folgend, wiederum durch das in Anspruch 1 spezifizierte Schichtsystem gebildet sind.

In einer weiteren Ausführungsvariante des erfindungsgemässen Substrates ist das mindestens eine Schichtsystem nach dem Wortlaut von Anspruch 20 aufgebaut, ein weiteres nach dem Wortlaut von Anspruch 21.

Dem Wortlaut von Anspruch 22 folgend, werden am erfindungsgemäss ausgebildeten Substrat in einer Ausbildungsvariante beidseits des Substrates gleiche Schichtsysteme vorgesehen.

Wie bereits mehrmals erwähnt, wird zum heutigen Zeitpunkt dem Einsatz von Hafnium-Oxinitrid nach Anspruch 23 bzw. 24 der Vorzug gegeben.

Dem Wortlaut von Anspruch 25 folgend, wird dabei der Brechungsindex des Hafnium-Oxinitrides zwischen 2,5 und 2,8 realisiert, bei Licht von 400nm.

Die erfindungsgemäss bevorzugterweise eingesetzte Hafnium-Oxinitridschicht weist im weiteren nach dem Wortlaut von Anspruch 26 einen Brechungsindex zwischen 2,5 und 2,8 auf und dabei eine Extinktionskonstante k von höchstens 0,02, vorzugsweise von höchstens 0,01.

Dem Wortlaut von Anspruch 27 folgend, sind am erfindungsgemässen Substrat mindestens die Oxinitridschicht, vorzugsweise alle Schichten, durch ein reaktives Dampfabscheidungsverfahren hergestellt, vorzugsweise durch reaktives Ionenplattieren oder reaktives Sputtern.

Aufgrund seiner ausgezeichneten Wärmeschutzwirkung, bei gleichzeitig optimierter Entspiegelung und Verschleiss-, damit Kratzfestigkeit, eignet sich das erfindungsgemässe Substrat ausgezeichnet für Scheiben, dabei insbesondere für Autoscheiben generell, dabei insbesondere auch für, was die Verschleissfestigkeit und die Entspiegelung anbelangt, höchste Anforderungen stellende Autowindschutzscheiben.

Bei der Entwicklung des erfindungsgemässen Substrates, Ausgangspunkt der vorliegenden Erfindung, wurde nun die weitere Erkenntnis gewonnen, dass nämlich bei der Herstellung von Schichten durch einen reaktiven Abscheidungsprozess (CVD oder PECVD oder reaktives Sputtern), bei welchem reaktiven Abscheidungsprozess ein Gasgemisch als Reaktionsgas dem Prozess zugeführt wird, der Beherrschung des dem Prozess zugeführten Gasgemisches, was das Mischungsverhältnis anbelangt, höchste Bedeutung zukommt.

Ein hierfür bekanntes Vorgehen, wonach einer Prozesskammer Behältnisse je mit den Gemischkomponenten angeschlossen werden und das Mischungsverhältnis durch entsprechende Bemessung des dem Prozess zugeführten Komponentenmassestromes über Stellventile eingestellt wird, zeigte sich als unbrauchbar.

Es wurde nun unter einem weiteren Aspekt der vorliegenden Erfindung erkannt, dass, um exakt voraussagbare und zeitlich konstant bleibende Mischungsverhältnisse zu realisieren, die Gasmischungskomponenten in einer von den Komponenten abhängigen Zeitspanne vor dem Prozesseinsatz gemischt werden müssen, im vorgegebenen Verhältnis. Die erwähnte Zeitspanne muss vorgesehen werden, um im Gasgemischtank ein homogenes Mischungsverhältnis über das Tankvolumen zu erwirken. Dies wird desto mehr notwendig, je ähnlicher die Mischgaskomponenten bezüglich ihrer Molekulargewichte sind.

Diese Erkenntnis schlägt sich erfindungsgemäss nun in einem Verfahren zur Herstellung der Oxinitridschicht, nach dem Wortlaut von Anspruch 30, nieder.

Für die im heutigen Zeitpunkt bevorzugte Herstellung von Hafnium-Oxinitridschichten mittels einer Ionenplattieranlage, wie beispielsweise einer Anlage des Typs BAP 800 der Firma Balzers AG, wie sie beispielsweise beschrieben ist in Proceedings Reprint, SPIE - The International Society for Optical Engineering, Reprinted from Optical Thin Films III: New Developments, 9 - 11 July 1990, San Diego, California, Vol. 1323, 19, 20, bzw. im Sonderdruck aus der Zeitschrift Metall Oberfläche, Zeitschrift für Oberflächenbearbeitung metallischer und nichtmetallischer Werkstoffe, 42. Jahrgang, 1988/10, Carl Hanser Verlag, München, R. Buhl und H.K. Pulker, Balzers/Liechtenstein, "Reaktives Ion-Plating zur Herstellung von Nitrid- und Oxid-Schichten", welche Schrift, was die erwähnten Ionenplattieranlagen anbelangt, zum integrierenden Bestandteil der vorliegenden Erfindung erklärt wird, wird nach dem Wortlaut von Anspruch 32 vorgegangen.

Im weiteren wurde bereits im Zusammenhang mit dem erfindungsgemässen Substrat erwähnt, dass ein bevorzugtes Herstellungsverfahren für sich folgende Schichten eines Oxinitrids und eines Nitrids darin besteht, von derselben Metallkomponente, gegebenenfalls in subnitridischer Form, auszugehen, also beispielsweise von Hafnium, und die sich folgenden Schichten ohne Prozessunterbruch mindestens durch schichtspezifische Aenderung des dem Prozess zugeführten Reaktionsgases aufzubringen, gemäss dem Wortlaut von Anspruch 33.

In einer heute bevorzugten Ausführungsform dieses Verfahrens wird nach dem Wortlaut von Anspruch 34 vorgegangen.

Eine Anlage zur Ausführung der genannten Verfahren ist in den Ansprüchen 35 bis 37 spezifiziert.

Im weiteren wurde im Zuge der genannten Entwicklung ein Hafnium-Oxinitrid als Schichtmaterial für ein Substrat nach Anspruch 1 höchst geeignet gefunden, nach dem Wortlaut von Anspruch 38, welches einen Brechungsindex zwischen 2,6 und 2,8 aufweist, und bei dem gleichzeitig der Extinktionskoeffizient k höchstens 0,02, vorzugsweise 0,01, beträgt, dies bei Licht von 400nm, vorzugsweise bei Licht zwischen 400nm und 1000nm.

Bevorzugterweise wird das erwähnte Hafnium-Oxinitrid mit einem Herstellungsverfahren nach mindestens einem der erwähnten Ansprüche 30 bis 34 hergestellt und weist, bevorzugterweise, als $HfO_xN_y$, die in Anspruch 41 spezifizierten x/y Werte auf.

Die der vorliegenden Erfindung zugrundegelegte Aufgabe wird primär durch den Einsatz mindestens einer Schicht aus Oxinitrid von Hafnium, Zirkonium, Tantal oder Titan erwirkt, ohne Einsatz einer Metallschicht. Die besten Resultate ergeben sich mit Einsatz von Hafnium-Oxinitrid, etwas schlechtere durch den Einsatz von Zirkon-Oxinitrid oder Tantal-Oxinitrid und, insbesondere was die Verschleissresistenz anbelangt, mit Titan-Oxinitrid die am wenigsten befriedigenden. Das Hafnium-Oxinitrid, welches die besten optischen und mechanischen Eigenschaften des Mehrschichtsystems ergibt, weist z.B.

- bei 400nm einen Brechungsindex von 2,7 und eine Extinktionskonstante von höchstens 0,01 auf,

- bei 800nm einen Brechungsindex von 2,55 und eine Extinktionskonstante k von höchstens 0,005 und

- bei 1000nm einen Brechungsindex von 2,53 bei einer Extinktionskonstante k von höchstens 0,001 auf.

Von diesen, bis zum heutigen Zeitpunkt als optimal befundenen Werten können durchaus Abweichungen in Kauf genommen werden, so dass sich beispielsweise für 400nm Brechungsindexwerte von 2,5 bis 3,0, vorzugsweise von 2,6 bis 2,8, bei Extinktionskonstanten k von höchstens 0,02, vorzugsweise 0,01, beim erfindungsgemäss beschichteten Substrat einsetzen lassen.

Die erfindungsgemäss eingesetzten Oxinitridschichten, und insbesondere das daraus hervorragende Hafnium-Oxinitrid, werden durch ein reaktives Bedampfungsverfahren hergestellt, sei dies durch Verdampfen des entsprechenden Metalles mittels geheizten Tiegels, mittels Elektronenstrahlverdampfen, oder sei dies durch reaktives Sputtern des entsprechenden Metalles von einem Targetobjekt.

Die Erfindung wird anschliessend beispielsweise anhand von Figuren und Beispielen erläutert:

Es zeigen:

Fig. 1            schematisch eine Ionenplattieranlage als Beispiel einer erfindungsgemäss eingesetzten reaktiven Beschichtungsanlage mit erfindungsgemässer Gaszuführung,

Fig. 2 bis 6        schematisch mehrere Konfigurationen des erfindungsgemässen, beschichteten Substrates,

Fig. 7.1          und zugehörig die Fig. 8.1, 9.1, 10.1, 11.1 und 12.1:
                  ein erfindungsgemässes, beschichtetes Substrat gemäss beschriebenem Beispiel 1 mit den zugehörigen Messresultaten,

Fig. 7.2          und zugehörig die Fig. 8.2, 9.2, 10.2.1, 10.2.2 und 12.2:
                  ein weiteres Ausführungsbeispiel des erfindungsgemäss beschichteten Substrates nach dem beschriebenen Beispiel 2 mit den zugehörigen Messresultaten,

Fig. 7.3          und zugehörig die Fig. 8.3, 9.3, 10.3 und 12.3:
                  ein drittes Ausführungsbeispiel des erfindungsgemässen Substrates mit zugehörigen Messresultaten entsprechend beschriebenem Beispiel 3,

Fig. 7.4 und 7.5    zwei weitere Ausführungsbeispiele des erfindungsgemässen Substrates nach den beschriebenen Beispielen 4 und 5.

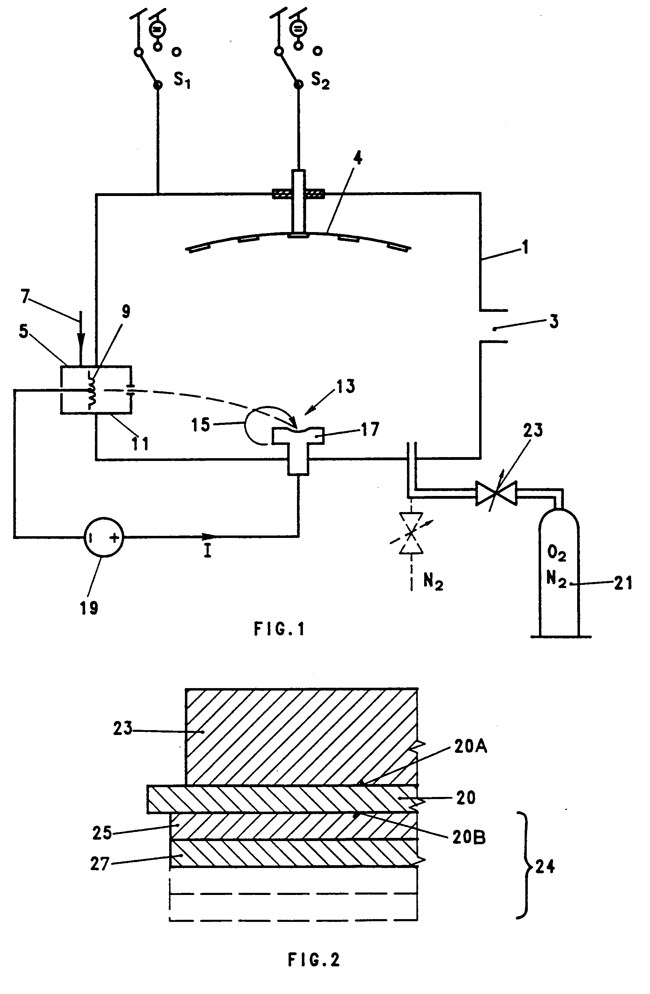

Die im heutigen Zeitpunkt bevorzugterweise eingesetzte Anlage ist in Fig. 1 schematisch dargestellt. Es handelt sich dabei um eine Ionenplattieranlage BAP 800 der Firma Balzers AG. Das erfindungsgemässe Oxinitrid kann aber durchaus mit einer anderen Anlage hergestellt werden, generell durch einen reaktiven Verdampfungsprozess CVD bzw. PECVD (chemical vapour deposition; plasma enhanced vapour deposition), wie durch reaktives Sputtern, sei dies mit DC oder AC, mit oder ohne Substratbias, oder durch thermisches Tiegelverdampfen.

Im heutigen Zeitpunkt wird bevorzugterweise die metallische Komponente, d.h. Hafnium, Zirkon, Tantal oder Titan, verdampft und mit dem $O_2/N_2$-Gasgemisch zur Reaktion gebracht, wobei es auch durchaus möglich ist, als Feststoff eine suboxidische oder subnitridische Verbindung der erwähnten Metalle zu verdampfen.

Die Anlage gemäss Fig. 1, entsprechend der Balzers BAP 800, umfasst eine Vakuumkammer 1 mit Pumpanschluss 3, einem Substratträger 4 in Form einer drehbaren Trägerkalotte, welche elektrisch isoliert in der Vakuumkammer 1 angeordnet ist. Eine Elektronenquelle 5 mit Gaseinlass 7, beispielsweise für Argon, umfasst einen thermischen Elektronenemitter, beispielsweise in Form einer Heizwendel 9 in der Elektronenkammer 11 mit (hier nicht dargestellten) Elektronenstrahlbündelungs-bzw. -beschleunigungsorganen.

Im weiteren ist, bezüglich der Vakuumkammer 1 elektrisch isoliert, eine Elektronenstrahlverdampfungsanordnung 13 vorgesehen mit um ca. 270° umgelenktem Elektronenverdampfungsstrahl 15 und dem schematisch dargestellten Tiegel 17. Der Elektronenemitter 9 ist bezüglich des Tiegels 17 über eine Quelle 19 kathodisch geschaltet, so dass die aus der Elektronenquelle 5 austretenden Elektronen auf den Tiegel 17 zu beschleunigt werden.

Das Gehäuse der Vakuumkammer 1 sowie die Substratträgerkalotte 4 werden, wie bei $S_1$ bzw. $S_2$ schematisch dargestellt, je auf Massepotential, auf einem Referenzpotential oder floatend betrieben.

Die erfindungsgemässen Oxinitridschichten wurden bis anhin mit der dargestellten Anlage hergestellt, dabei schwergewichtig Hafnium-Oxinitrid.

Die Substrate und entsprechend die Trägerkalotte 4 wurden floatend betrieben und die Kammerwandung 1 auf Massepotential gelegt. Im Tiegel 17 wurde das Metall elektronenstrahlverdampft. Folgende Prozessgrössen wurden eingestellt:

- Argonpartialdruck: $3 \cdot 10^{-4}$mbar,

- Partialdruck des $O_2/N_2$-Gemisches: $5 \cdot 10^{-4}$mbar,

- $O_2/N_2$-Gemisch: 22Gew% $O_2$, 78Gew% $N_2$,

- Entladestrom I: 60A,

- Beschichtungsrate: 0,3nm/sec.

Von ausschlaggebender Wichtigkeit ist bei allen erwähnten reaktiven Dampfabscheidungsverfahren des erfindungsgemässen Oxinitrides die Art und Weise, wie das Reaktionsgasgemisch der jeweiligen Prozesskammer zugeführt wird. Wie anhand der erwähnten, im heutigen Zeitpunkt verwendeten Anlage dargestellt, wird ein Gastank 21, beispielsweise in Form einer Gasflasche, über ein Regulierventil 23 mit der Prozesskammer verbunden, wobei im Gastank 21 bereits das Reaktionsgasgemisch bereitgestellt ist in dem geforderten Verhältnis seiner Gaskomponenten.

Im Tank 21 wird der notwendige Anteil der Gaskomponenten lange vor Prozessbeginn bereitgestellt, derart, dass sich, in Abhängigkeit des verwendeten Gemisches im Tank 21, eine homogene Durchmischung ergibt. Im angesprochenen Falle der Oxinitridschichtherstellung wurde gefunden, dass diese Homogenisierung des Gemisches im Tank 21 frühestens nach 24 Stunden, vorzugsweise nach einer längeren Zeit, in ausreichendem Masse sich im Tank 21 einstellt.

Auf diese Art und Weise wurden Hafnium-Oxinitridschichten auf den Substraten aus Klarglas oder eingefärbtem Glas aufgebracht, wobei sich die Hafnium-Oxinitridschicht durch folgende ausgezeichneten optischen Werte auszeichnete:

|  | Brechungsindex | Extinktionskonstante k |
|---|---|---|
| 400nm | 2,7 | k < = 0,01 |
| 800nm | 2,55 | < = 0,005 |
| 1000nm | 2,53 | < = 0,001 |

Ebenso wie bei der Hafnium-Oxinitridschicht, geringfügig schlechter, bewegten sich die optischen Werte Brechungsindex und Extinktionskonstante k von Zirkon-Oxinitrid, Tantal-Oxinitrid und Titan-Oxinitrid in einem Bereich von 2,5 bis 3,0 bzw. k < = 0,02 im angegebenen Wellenlängenbereich. Beim wie erwähnt hergestellten $HfO_xN_y$ wurden $\frac{x}{y}$-Werte nach der RBS-Methode (Rotherford backscattering) gefunden:

$$1,5 \leq \frac{x}{y} \leq 3,$$

wobei die erwähnten ausgezeichneten Eigenschaften sich insbesondere bei

$$1,5 \leq \frac{x}{y} \leq 2$$

ergeben, dabei vor allem bei

$$1,6 \leq \frac{x}{y} \leq 1,7.$$

Die ausgezeichneten Resultate wurden bei

$$1,6 \leq \frac{x}{y} \leq 1,7;$$

vor allem bei

$$\frac{x}{y} \approx 1,7$$

gemessen, wobei auch bei den erwähnten $\frac{x}{y}$-Bereichen sich ähnlich gute Resultate ergeben, die ein HfON mit für dieses Material neuartigen und erfinderischen Eigenschaften definieren.

Es werden nun anschliessend mit den erfindungsgemässen Oxinitriden als ausschlaggebende Komponente beschichtete Substrate beschrieben, welche die eingangs gestellte Aufgabe lösen, wobei die Oxinitridschichten nach einem der erwähnten Verfahren hergestellt sind, welchen das erfindungsgemäss vorab gemischte und homogenisierte Reaktionsgasgemisch gemeinsam ist.

In Fig. 2 bezeichnet 20 das unbeschichtete Substrat, vorzugsweise aus Glas, sei dies Grünglas, Klarglas oder einem anders gefärbten Glas. Auf der einen Substratseite 20A ist bevorzugterweise ein noch zu beschreibendes Schichtsystem 23 vorgesehen, auf der zweiten Seite 20B das anhand von Fig. 2 genauer dargestellte zweite Schichtsystem 24.

Ob nur einseitig am Substrat ein Schichtsystem vorgesehen ist oder beidseitig, in jedem Falle umfasst das oder jedes der Schichtsysteme mindestens eine Schicht eines der erwähnten erfindungsgemässen Oxinitride, vorzugsweise vom erwähnten, neuartigen Hafnium-Oxinitrid. Da sich gezeigt hat, dass insbesondere Hafnium-Oxinitrid, Zirkon-Oxinitrid und Tantal-Oxinitrid eine ausgezeichnete Verschleissresistenz aufweisen, wird bevorzugterweise am einen oder an beiden der vorgesehenen Schichtsysteme mindestens die zweitäusserste Schicht aus einem der erwähnten, verschleissresistenten Oxinitride gebildet.

Wie noch ausgeführt werden wird, können durchaus beide Schichtsysteme 23 und 24 gleich aufgebaut sein. In Minimalkonfiguration besteht das System 24 aus einer Schicht hochbrechenden Materials 25 und einer Schicht niedrigbrechenden Materials 27. In dieser Konfiguration ist die Schicht hochbrechenden Materials gebildet aus einem der erwähnten erfindungsgemässen Oxinitride, die Schicht niedrigbrechenden Materials 27 vorzugsweise aus Siliziumoxid.

Wie gestrichelt in Fig. 2 dargestellt, kann das System 24 eine weitere Abfolge von Schichten hoch- und niedrigbrechender Materialien aufweisen, wobei dann, wie erwähnt wurde, mindestens die zweitäusserste Schicht aus dem erfindungsgemässen Oxinitrid besteht, bevorzugterweise aus dem Hafnium-Oxinitrid. Wiederum wird als niedrigbrechendes Schichtmaterial vorzugsweise Siliziumoxid eingesetzt.

Bevorzugterweise werden gleichermassen alle Schichten hochbrechenden Materials am ein- oder beidseitig vorgesehenen System 24 aus einem der erfindungsgemässen Oxinitride aufgebaut, vorzugsweise alle aus Hafnium-Oxinitrid. Auch das Aufbringen der Schichten niedrigbrechenden Materials, vorzugsweise Siliziumoxid, wird durch einen reaktiven Bedampfungsprozess hergestellt, sei dies reaktives Ionenplattieren, reaktives Elektronenstrahlverdampfen, reaktives Tiegelverdampfen (geheizter Tiegel) oder reaktives Sputtern. Die optischen Kennwerte, Brechungsindex und Extinktionskonstante, der hochbrechenden Schichtmaterialien aus den erfindungsgemässen Oxinitriden bewegen sich im obgenannten Bereich, Brechungsindex 2,5 bis 3, Extinktionskonstante $k < = 0,02$, zwischen 380nm und 1000nm.

Aufgrund der ausgezeichneten optischen Eigenschaften der erfindungsgemässen Oxinitridschicht, insbesondere derjenigen des hervorragenden erfindungsgemässen Hafnium-Oxinitrides, wird im sichtbaren Lichtbereich eine ausgezeichnete Entspiegelung bis hin zu hohen Einfallswinkeln möglich, und gleichzeitig wird eine hohe Reflexion bei geringer Absorption im nahen Infrarotbereich erwirkt. M.a.W. lässt sich eine steile Flanke des Reflexionsvermögens im interessierenden Spektralbereich zwischen sichtbarem Licht und nahem Infrarot, in welch letzterem die Sonnenstrahlung hohe Energien aufweist, realisieren, welcher steile Uebergang gerade optimal im Uebergangsbereich zwischen sichtbarem Licht und nahem Infrarot, also bei ca. 800nm, auftritt. Damit wird eine breitbandig wirkende Entspiegelung im sichtbaren Lichtbereich realisierbar bei minimal gehaltener Schichtanzahl und optimaler Wärmeschutzwirkung.

Die erwähnte Breitbandigkeit der tiefen Reflexion im sichtbaren Lichtbereich reduziert offensichtlicherweise die Farbempfindlichkeit des Entspiegelungsverhaltens des oder der erfindungsgemässen Schichtsysteme.

Durch gezielten Einsatz zweier beidseitiger Schichtsysteme, wie noch zu beschreiben sein wird, lässt sich die optische Wirkung des Gesamtsystems wesentlich über diejenige der einzelnen Schichtsysteme, wie des beschriebenen Systems 24, erhöhen.

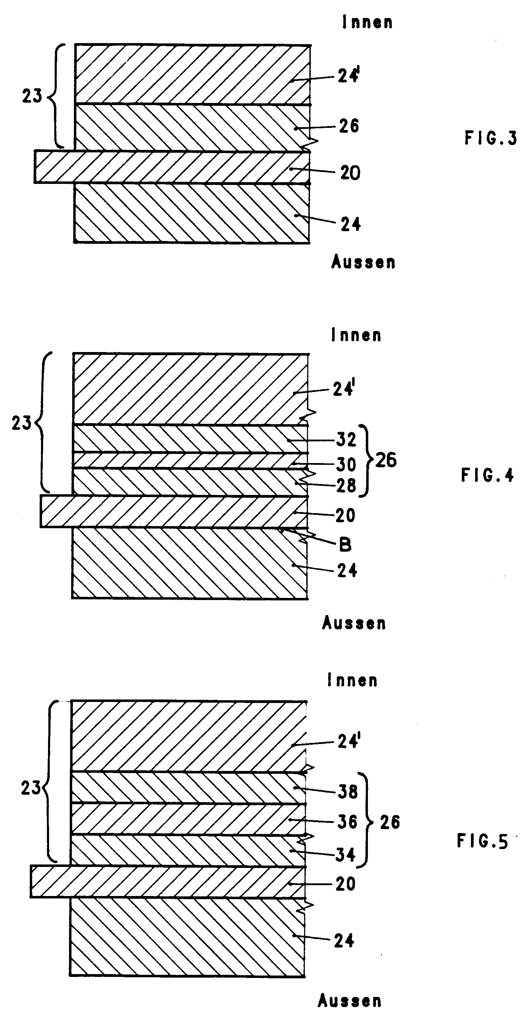

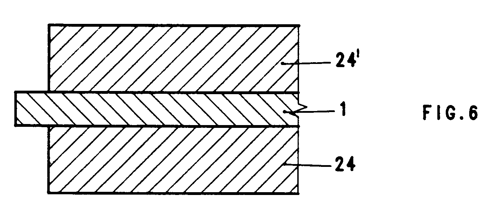

Bei einer doppelseitig mit Schichtsystem versehenen Substrat 20 gemäss Fig. 3 ist auf einer Seite das anhand von Fig. 2 beschriebene Schichtsystem 24 vorgesehen, auf der anderen Substratseite das Schichtsystem 23. Für Scheibenanwendungen, insbesondere für Autoscheiben, dabei besonders für Autowindschutzscheiben, die höchsten Anforderungen, was optische Eigenschaften und mechanische anbelangt, genügen müssen, liegt das Schichtsystem 23 raumseitig. Das Schichtsystem 23 umfasst ein Systemteil 26, welches als eigentliches Wärmeschutzsystem ausgebildet ist und gemäss Fig. 4 eine erste Schicht 28 eines der erfindungsgemässen Oxinitride, bevorzugterweise Hafnium-Oxinitrid, umfasst. Darüber ist eine dünnere, metallische Nitridschicht 30 des Hafniums, Zirkons, Tantals oder Titans vorgesehen, bevorzugterweise wiederum des Hafniums.

Ueber der metallischen Nitridschicht ist wiederum eine Oxinitridschicht 32 vorgesehen, gefolgt von der Minimalkonfiguration des Schichtsystems 24, wie anhand von Fig. 2 erläutert.

In bevorzugter Art und Weise werden sich folgende Oxinitrid- und Nitridschichten von derselben Metallkomponente gebildet und bevorzugterweise vom Metall Hafnium oder einem Sub-Hafniumnitrid. Rückblickend auf die zur Erläuterung des erfindungsgemässen Herstellungsverfahrens in Fig. 1 dargestellte erfindungsgemässe Anlage ergibt dies die höchst einfache Herstellungsmöglichkeit der Oxinitrid/Nitridschichtabfolgen dadurch, dass ohne Prozessunterbruch auf einer aufgebrachten Oxinitrid- bzw. Nitridschicht entsprechend eine Nitrid- bzw. Oxinitridschicht aufgebracht wird dadurch, dass mindestens das dem Prozess zugeführte Reaktionsgas gewechselt wird bzw. dessen Gemisch, im angesprochenen Falle von $N_2$ zu $O_2/N_2$ bzw. umgekehrt. Selbstverständlich werden die übrigen Prozessparameter nach Notwendigkeit nachgeführt.

Damit ergibt sich ein grundsätzlich erfindungsgemässes Herstellungsverfahren sich folgender Schichten unterschiedlicher Materialien, basierend je auf derselben Feststoffkomponente, darin, dass der Prozess ununterbrochen fortgeführt wird und bei Verdampfen ein und desselben Feststoffes die Schichtabfolge durch Aenderung der Reaktionsgas- bzw. Reaktionsgasgemischzufuhr gesteuert wird.

In Fig. 4 ist das im Schichtsystem 23 als Teilsystem eingesetzte Schichtsystem 24 gemäss Fig. 2 mit 24' bezeichnet.

Das Schichtsystem 23 gemäss den Fig. 3 bzw. 4 ist aufgrund der vorgesehenen, mindestens einen Nitridschicht als metallisch-dielektrisches System zu bezeichnen, während das Schichtsystem 24, ausschliesslich aus Oxinitrid-chichten und Schichten niedrigbrechenden Materials, vorzugsweise $SiO_2$, gebildet, als dielektrisches zu bezeichnen ist.

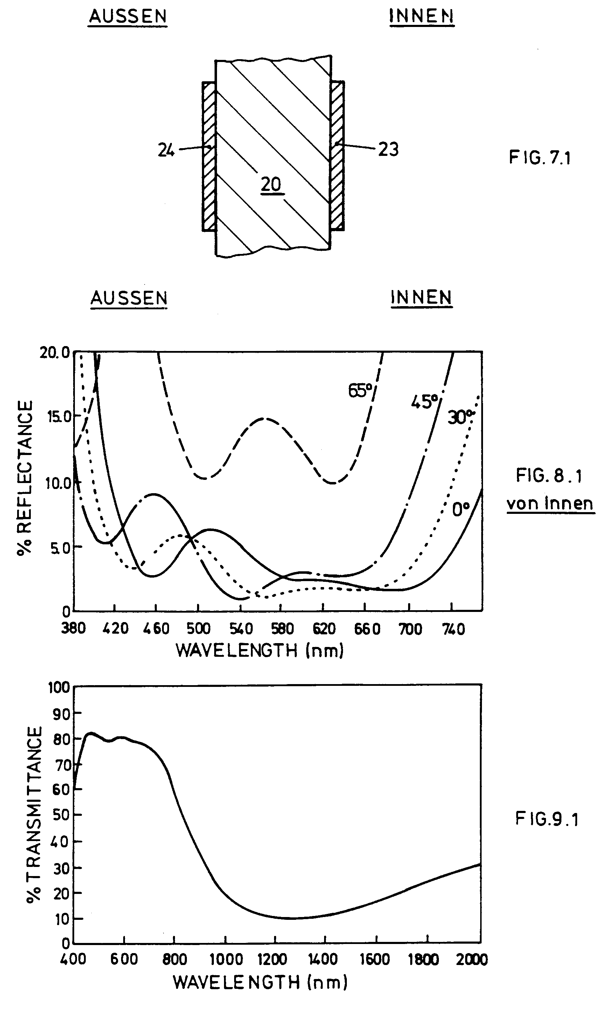

In Fig. 5 ist eine weitere Ausführungsvariante des vornehmlich Wärmeschutzwirkung erbringenden Teils 26 des Schichtsystems 23 dargestellt. Es umfasst auf dem Substrat 20 eine erste Schicht 34 aus Indium-Zinnoxid (ITO), gefolgt von einer Schicht 36 eines niedrigbrechenden Materials, wie erwähnt wurde, vorzugsweise aus Siliziumoxid, wiederum gefolgt von einer Schicht 38 aus dem erwähnten Indium-Zinnoxid. Es folgt wiederum, hier als Teilsystem, das anhand von Fig. 2 erläuterte Schichtsystem 24, mindestens in seiner Minimalkonfiguration.

Mit den anhand von Fig. 5 erläuterten Schichtsystemen 23 und 24 werden vornehmlich Grüngläser ohne wesentliche Reduktion ihres Transmissionsverhaltens im sichtbaren Lichtbereich beschichtet.

Fig. 6 zeigt eine weitere Ausführungsvariante des erfindungsgemässen, beschichteten Substrates, bei welchem beidseitig ein dielektrisches Schichtsystem entsprechend 24, 24' vorgesehen ist.

Beispiel 1:

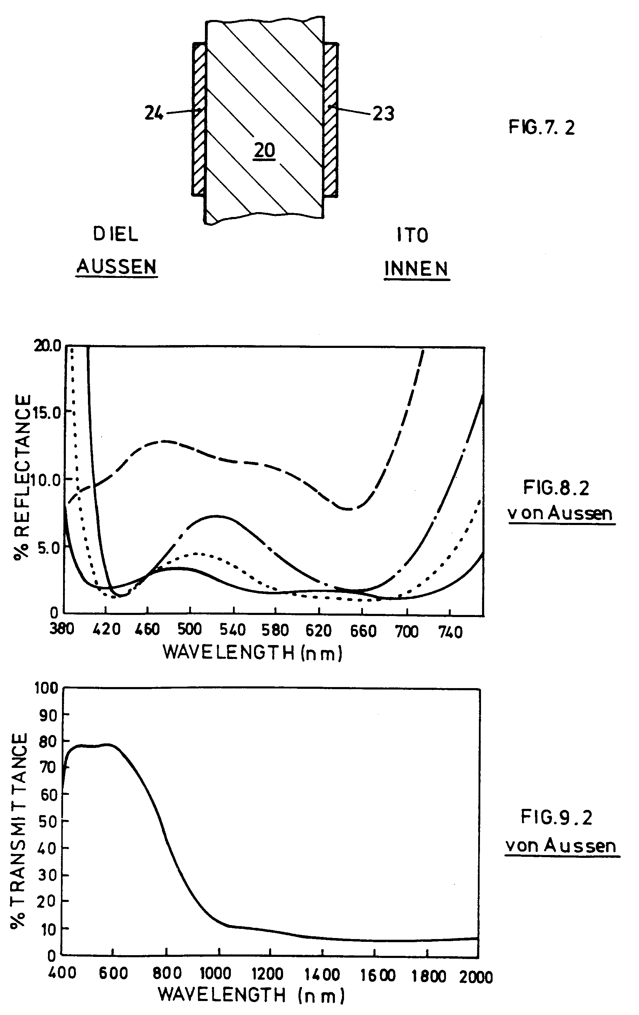

Gemäss Fig. 7.1 wurde auf dem Klarglassubstrat 20, für die Anwendung als Aussenscheibe, auf Rauminnenseite das erwähnte dielektrisch/metallische Schichtsystem 23, grundsätzlich aufgebaut wie in Fig. 4 erläutert, vorgesehen, aussenseitig das dielektrische Schichtsystem 24. Das d/m-Schichtsystem 23 ist gemäss Tabelle 1.1. aufgebaut:

Tabelle 1.1

|  | HfON | HfN | HfON | $SiO_2$ | HfON | $SiO_2$ |
|---|---|---|---|---|---|---|
|  | 38 | 14 | 43 | 182 | 95 | 81 [nm] |
| optische Dicke | .2H | - | .22H | .54L | .49H | .24L |
| Design-Wellenlänge $\lambda_d$: 500nm |  |  |  |  |  |  |

Dabei sind die Angaben bezüglich der optischen Dicke nach folgender Konvektion aufgeführt:

Es bezeichnet H eine Schicht mit der optischen Dicke einer Design-Wellenlänge $\lambda_d$ eines hochbrechenden Materials. Die optische Dicke ergibt sich aus dem Produkt aus Brechungsindex bei Design-Wellenlänge und physikalischer (gemessener) Dicke.

Analog bezeichnet L eine Schicht mit der optischen Dicke einer Design-Wellenlänge eines Materials mit niedrigem Brechungsindex.

Das dielektrische Schichtsystem 24 seinerseits ist aufgebaut, wiederum ausgehend vom Substrat, gemäss Tabelle 1.2:

Tabelle 1.2

|  | HfON | $SiO_2$ | HfON | $SiO_2$ | HfON | $SiO_2$ |
|---|---|---|---|---|---|---|
|  | 8 | 42 | 103 | 193 | 98 | 95 [nm] |
| optische Dicke | .04H | .125L | .53H | .57L | .505H | .28L |
| Design-Wellenlänge $\lambda_d$: 500nm |  |  |  |  |  |  |

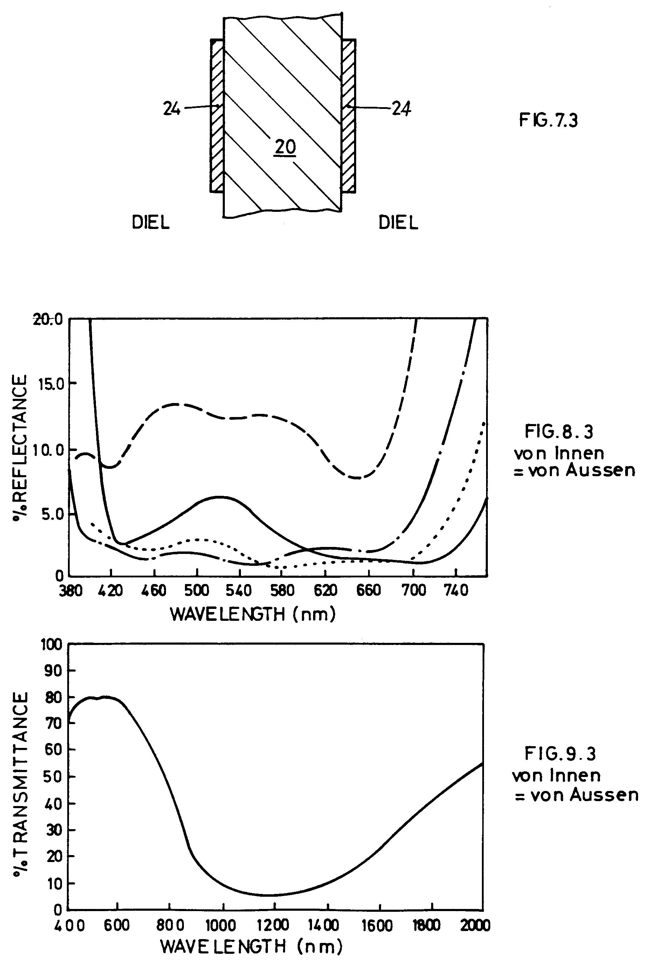

Das Reflexionsverhalten im sichtbaren Lichtbereich dieses erfindungsgemässen Systems ist in Fig. 8.1 dargestellt, für Einfallswinkel von 65°, 45°, 30° und 0°.

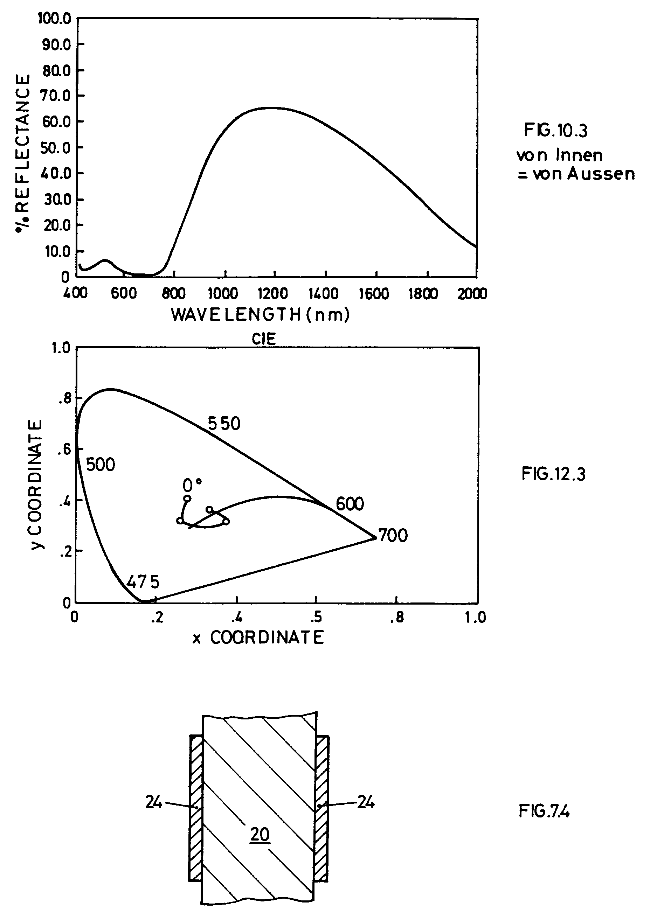

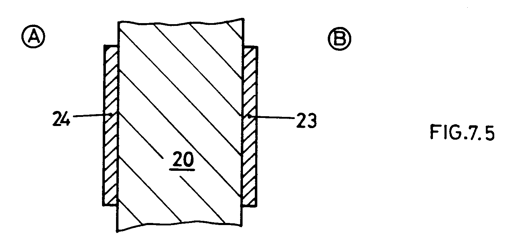

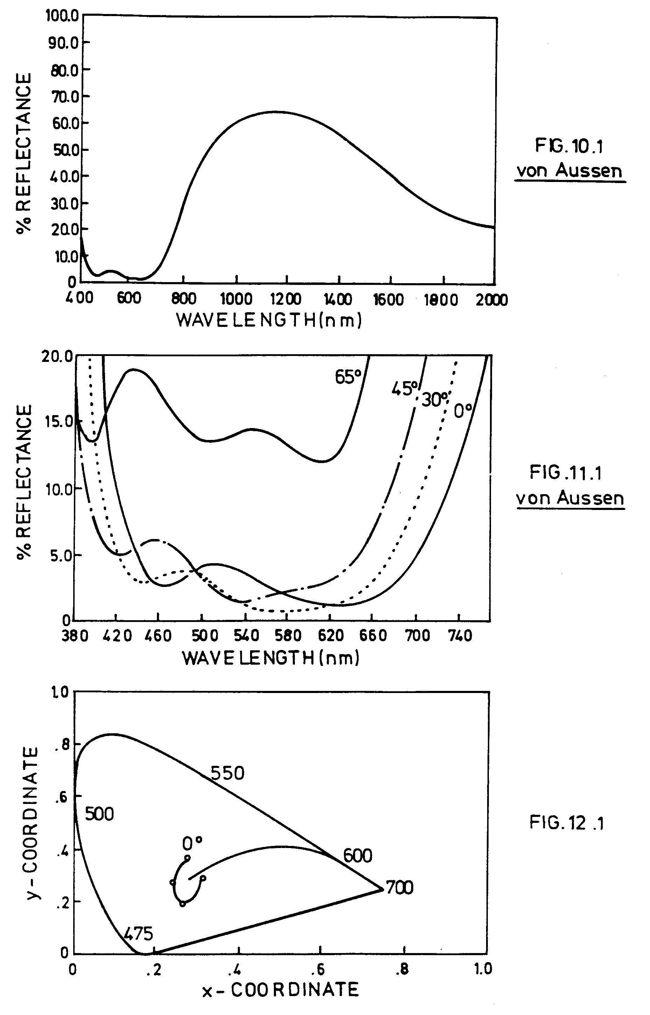

In Fig. 9.1 ist das Transmissionsverhalten des Gesamtsystems für Sonneneinstrahlung von 340nm bis 2000nm dargestellt. In Fig. 10.1 ist das entsprechende Reflexionsverhalten dargestellt, bei Lichteinfall von aussen.

Die Reflexionsaufnahme gemäss Fig. 8.1 bezieht sich auf die Innenseite, die Reflexionsaufnahmen gemäss Fig. 10.1 auf die Aussenseite. Die in Fig. 11.1 dargestellten Reflexionsverläufe bei unterschiedlichen Einfallswinkeln im sichtbaren Spektralbereich sind von aussen aufgenommen.

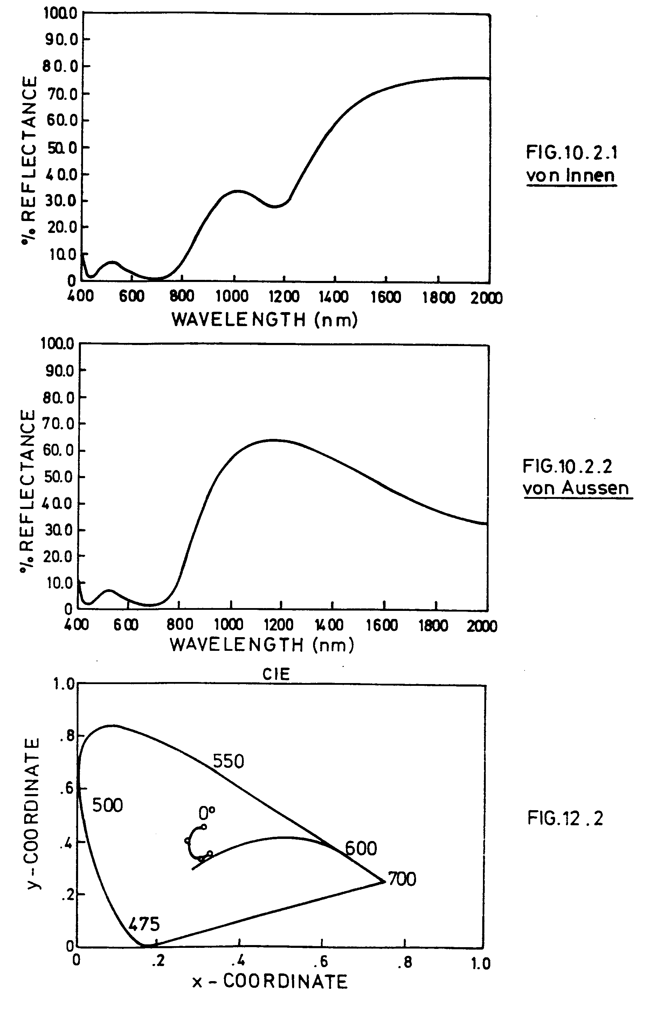

In Fig. 12.1 sind mit x und y die Farbkoordinatenwerte angegeben, welche als Funktion des Lichteinfallswinkels den Farbumschlag in der Reflexion charakterisieren. Dabei bezeichnen x, y Normfarbwertanteile gemäss der Normfarbtafel nach DIN 5033.

Nachfolgend sind die erzielten Resultate wie folgt zusammengestellt:

Tabelle 1.3 zeigt in Abhängigkeit des Einfallswinkels die $R_{vis}$-Werte des erfindungsgemässen Systems mit Klarglas sowie von Grünglas (unbeschichtet) und von Klarglas (unbeschichtet), am System gemäss Fig. 7.1.

Tabelle 1.3

| | $R_{vis}$ | | |
|---|---|---|---|
| | System | Grünglas | Klarglas |
| 0° | 3,9% | 7,2% | 8,2% |
| 30° | 2,2% | 7,4% | 8,4% |
| 45° | 2,4% | 8,6% | 9,8% |
| 65° | 13,0% | 17,9% | 20,3% |

In Tabelle 1.4 sind die Werte $T_{SONNE}$, $R_{SONNE}$ sowie $T_{vis}$ angegeben, wiederum für das erfindungsgemässe System gemäss Fig. 7.1, weiter für unbeschichtetes Grünglas und Klarglas.

Tabelle 1.4

| | System | Grünglas | Klarglas |
|---|---|---|---|
| $T_{SONNE}$ | 51% | 57% | 92% |
| $R_{SONNE}$ | 28% | 6% | 8% |
| $T_{vis}$ | 76% | 80% | 92% |

Beispiel 2:

Gemäss Fig. 7.2 wurde auf Grünglas als Substrat 20 innenliegend ein System 23 gemäss Fig. 5 vorgesehen, aussenliegend eine dielektrische Beschichtung gemäss zweitem Schichtsystem 24. Der Aufbau des ersten Schichtsystems 23 ist in Tabelle 2.1 zusammengestellt. Dabei bezeichnet I die zu H bzw. L analoge Grösse für ITO.

Tabelle 2.1

| | ITO | SiO$_2$ | ITO | SiO$_2$ | HfON | SiO$_2$ |
|---|---|---|---|---|---|---|
| | 13 | 40 | 137 | 199 | 97 | 98 [nm] |
| optische Dicke | .05I | .12L | .55I | .59L | .5H | .29L |
| Design-Wellenlänge $\lambda_d$ = 500nm | | | | | | |

Der Aufbau des zweiten Systems 24 ist wie in Tabelle 1.2 beschrieben.

Die bereits anhand von Beispiel 1 besprochenen Verläufe sind, entsprechend, in den Fig. 8.2 dargestellt, im weiteren in Fig. 9.2; Fig. 10.2.1 ist am System gemäss Fig. 7.2 von innen her aufgenommen; Fig. 10.2.2 von aussen, und die Darstellung von Fig. 12.2 ist analog derjenigen von Fig. 12.1 zu Beispiel 1.

Die nachfolgenden Tabellen 2.3 und 2.4 lassen die resultierenden Kennwerte klar erkennen.

Tabelle 2.3

| | $R_{vis}$ | | |
|---|---|---|---|
| | System | Grünglas | Klarglas |
| 0° | 5,2% | 7,2% | 8,2% |
| 30° | 2,7% | 7,4% | 8,4% |
| 45° | 2,0% | 8,6% | 9,8% |
| 65° | 10,9% | 17,9% | 20,3% |

Tabelle 2.4

| | System | Grünglas | Klarglas |
|---|---|---|---|
| $T_{SONNE}$ | 43% | 57% | 92% |
| $R_{SONNE}$ | 22% | 6% | 8% |
| $T_{vis}$ | 78% | 80% | 92% |

Beispiel 3:

Es wurde gemäss Fig. 7.3 als Substrat 20 Grünglas eingesetzt und innen und aussen je ein Schichtsystem 24 gemäss Fig. 6 aufgebracht. Der Aufbau beider Schichtsysteme 24 entspricht dem in Tabelle 1.2 wiedergegebenen.

In den Fig. 8.3, 9.3, 10.3 und 12.3 sind die anhand des Beispiels 1 definierten Grössen wiedergegeben. Es ergeben sich weiter:

Tabelle 3.3

| | $R_{vis}$ | | |
|---|---|---|---|
| | System | Grünglas | Klarglas |
| 0° | 4,1% | 7,2% | 8,2% |
| 30° | 1,5% | 7,4% | 8,4% |
| 45° | 1,5% | 8,6% | 9,8% |
| 65° | 11,8% | 17,9% | 20,3% |

Tabelle 3.4

| | System | Grünglas | Klarglas |
|---|---|---|---|
| $T_{SONNE}$ | 45% | 57% | 92% |
| $R_{SONNE}$ | 22% | 6% | 8% |
| $T_{vis}$ | 79% | 80% | 92% |

Im weiteren werden zwei erfindungsgemässe Beispiele angegeben, welche für 0° Einfallswinkel optimiert sind, so z.B. für Seitenscheiben an Autos oder andere, eher kostengünstig entspiegelte Wärmeschutzgläser, wie beispielsweise für Kunstobjekte.

Beispiel 4:

Es wurde gemäss Fig. 7.4 als Substrat 20 Grünglas eingesetzt, welches beidseitig gemäss Fig. 6 mit einem dielektrischen Schichtsystem beschichtet wurde.

Der Aufbau beider Schichtsysteme ist in Tabelle 4.1 wiedergegeben.

Tabelle 4.1

|  | HfOn | SiO$_2$ | HfON | SiO$_2$ | HfON | SiO$_2$ |
|---|---|---|---|---|---|---|
|  | 10 | 37 | 103 | 172 | 99 | 86 [nm] |
| optische Dicke | .05H | .11L | .53H | .51L | .51H | .254L |
| $\lambda d = 500nm.$ | | | | | | |

Es wurden am System gemäss Fig. 7.4, für 0° Einfallswinkel optimiert, die in Tabelle 4.2 wiedergegebenen Werte gemessen.

Tabelle 4.2

|  | System | Grünglas | Klarglas |
|---|---|---|---|
| $R_{vis}$, 0° | < 0,7% | 7,2% | 8,2% |
| $T_{vis}$, 0° | 82% | 80% | 92% |
| $T_{SONNE}$, 0° | 45% | 57% | 92% |
| $R_{SONNE}$, 0° | 22% | 6% | 8% |

Beispiel 5:

Es wurde gemäss Fig. 8.5 an einem Substrat 20 auf Klarglas Schichtsysteme 24 bzw. 23, d.h. ein dielektrisches 24 und ein dielektrisch/metallisches 23 aufgebracht. Das dielektrische System 24 ist gemäss demjenigen von Beispiel 4 aufgebaut. Das metallisch/dielektrische System 23 ist wie in Tabelle 5.1 aufgebaut:

Tabelle 5.1

|  | HfON | HfN | HfON | SiO$_2$ | HfON | SiO$_2$ |
|---|---|---|---|---|---|---|
| Dicke optische | 25 | 17 | 43 | 190 | 105 | 22 [nm] |
| Dicke | .13H | - | .22H | .56L | .54H | .26L |

Gemessen wurden die in Tabelle 5.2 wiedergegebenen Werte:

Tabelle 5.2

|  | System | Grünglas | Klarglas |
|---|---|---|---|
| $R_{vis}$, 0°, Betrachtung von A | 4,5% | 7,2% | 8,2% |
| $R_{vis}$, 0°, Betrachtung von B | < = 1% | 7,2% | 8,2% |
| $T_{vis}$, 0° | 75% | 80% | 92% |
| $T_{SONNE}$, 0° | 50,5% | 57% | 92% |
| $R_{SONNE}$, 0°, Beobachtung von A | 28% | 6% | 8% |
| $R_{SONNE}$, 0°, Beobachtung von B | 22% | 75,5% | 92% |

Selbstverständlich können auch die ITO-Systeme auf 0° Einfallswinkel optimiert werden.

Mithin können erfindungsgemäss unter der Verwendung der erfindungsgemässen Oxinitride auf sehr gute entspiegelte Wärmeschutzsysteme, für 0° optimiert, realisiert werden. Selbstverständlich können die oben beschriebenen Systeme je nach Einsatzzweck bezüglich "innen" und "aussen" vertauscht werden.

Das dielektrische System kann ein 4-, 6-, 8-, etc.-Schichter sein, entsprechend dem allgemeinen Aufbau:

Substrat [0.1H 0.1L (0.5H 0.5L)$^x$ 0.5H 0.25L], wobei x hier ein Wiederholfaktor mit x = 0,1, 2 ... ist, der innerhalb der ( ) notierten Schichten darstellt.

Auch das metallisch/dielektrische Schichtsystem kann auf 6, 8, ... Schichten ausgedehnt werden, etwa nach dem Muster:

Substrat [0.1H N 0.1H 0.5L (0.5H 0.5L)$^x$ 0.5H 0.25L] mit dem Wiederholfaktor x = 0,1, 2 ... .

Als Vierschichter kann weiter das ITO-System aufgebaut werden nach dem Muster:

0.1I 0.1L 0.5I 0.25L,

als Fünfschichter:

0.1I 0.1L 0.5I 0.5H 0.25L.

bzw. allgemein:

0.1I 0.1L 0.5I 0.5L (0.5H 0.5L)$^x$ 0.5H 0.25L mit dem Wiederholfaktor x = 1,2 ... .

Die oben dargestellten Beispiele stellen jeweils ein Optimum bezüglich Wärmeschutz, Entspiegelung und Einfachheit (Kosten!) dar.

Selbstverständlich kann mit mehr Schichten die Wärmeschutzwirkung verbessert werden, wobei die Entspiegelungswirkung schlechter werden kann und höhere Kosten anfallen.

**Patentansprüche**

1. Beschichtetes, transparentes Substrat, dadurch gekennzeichnet, dass mindestens auf der einen Substratseite ein mindestens zweischichtiges, transparentes, metallschichtfreies Schichtsystem aufgebracht ist mit mindestens einer Schicht des Oxinitrides von Hafnium, Zirkon, Tantal oder Titan, zur Reduktion der Sonnenstrahlungs-Transmission ($T_{SONNE}$) und zur Reduktion der Reflexion ($R_{vis}$) von sichtbarem Licht.

2. Substrat nach Anspruch 1, dadurch gekennzeichnet, dass die Oxinitridschicht eine Dicke von mindestens 30nm, vorzugsweise von mindestens 50nm aufweist.

3. Substrat nach Anspruch 2, dadurch gekennzeichnet, dass die Oxinitridschicht eine Dicke von mindestens 70nm aufweist, vorzugsweise von mindestens 90nm.

4. Substrat nach einem der Ansprüche 1 bis 3, dadurch gekennzeichnet, dass auf der zweiten Substratseite ein mindestens zweischichtiges Schichtsystem aufgebracht ist mit mindestens einer Schicht des Oxinitrides von Hafnium, Zirkon, Tantal oder Titan.

5. Substrat nach einem der Ansprüche 1 bis 4, dadurch gekennzeichnet, dass mindestens auf einer Substratseite das Schichtsystem mindestens eine Nitridschicht des Hafniums, Zirkons, Tantals oder Titans aufweist oder mindestens eine Indium-Zinnoxidschicht.

6.  Substrat nach Anspruch 5, dadurch gekennzeichnet, dass das Nitrid dasjenige desselben Metalles ist, von welchem das Oxinitrid gebildet ist.

7.  Substrat nach Anspruch 6, dadurch gekennzeichnet, dass sich Nitrid- und Oxinitridschichten unmittelbar folgen.

8.  Substrat nach einem der Ansprüche 1 bis 7, dadurch gekennzeichnet, dass eine Schicht aus dem Oxinitrid die zweitäusserste Systemschicht bildet.

9.  Substrat nach einem der Ansprüche 1 bis 8, dadurch gekennzeichnet, dass seine Transmission mindestens in wesentlichen Teilen des sichtbaren Lichtbereiches mindestens 70%, vorzugsweise mindestens 75%, ist.

10. Substrat nach einem der Ansprüche 1 bis 9, dadurch gekennzeichnet, dass bis zu Einfallswinkeln von mindestens 60°, vorzugsweise von mindestens 65°, die Reflexion mindestens in wesentlichen Teilen des sichtbaren Lichtbereiches bezüglich derjenigen am nicht beschichteten Substrat reduziert ist.

11. Substrat nach einem der Ansprüche 1 bis 9, dadurch gekennzeichnet, dass mindestens im Spektralbereich von 520nm bis 620nm und mindestens einseitig die Reflexion höchstens 18%, vorzugsweise höchstens 15%, beträgt, dies bevorzugterweise bis zu Einfallswinkeln von mindestens 60°, vorzugsweise von mindestens 65°.

12. Substrat nach einem der Ansprüche 1 bis 11, dadurch gekennzeichnet, dass die Transmission mindestens im Spektralbereich von 450nm bis 600nm mindestens 70%, vorzugsweise mindestens 75%, ist.

13. Substrat nach einem der Ansprüche 1 bis 12, dadurch gekennzeichnet, dass der Brechungsindex des Oxinitrides mindestens einer der Schichten 2,5 bis 3, vorzugsweise 2,6 bis 2,8, ist, für Licht von 400nm, dabei vorzugsweise die Extinktionskonstante k höchstens 0,02, vorzugsweise höchstens 0,01, ist.

14. Substrat nach einem der Ansprüche 1 bis 13, dadurch gekennzeichnet, dass das Substrat Glas ist.

15. Substrat nach einem der Ansprüche 1 bis 14, dadurch gekennzeichnet, dass mindestens ein Schichtsystem aus einer Abfolge von Hafnium-Oxinitrid und Siliziumoxid besteht, vorzugsweise, vom Substrat her betrachtet, wie folgt:

    -   8nm HfON,

    -   42nm $SiO_2$,

    -   103nm HfON,

    -   193nm $SiO_2$,

    -   98nm HfON,

    -   95nm $SiO_2$.

16. Substrat nach einem der Ansprüche 1 bis 15, dadurch gekennzeichnet, dass mindestens ein Schichtsystem, vom Substrat her betrachtet, wie folgt aufgebaut ist:

    -   eine Schicht des Oxinitrides von Hafnium, Zirkon, Tantal oder Titan,

    -   eine Nitridschicht vorzugsweise desselben Metalles,

    -   eine Oxinitridschicht vorzugsweise desselben Metalles,

    -   weitere Schichten.

17. Substrat nach Anspruch 16, dadurch gekennzeichnet, dass die weiteren Schichten durch ein Schichtsystem nach Anspruch 1 gebildet sind.

18. Substrat nach einem der Ansprüche 1 bis 17, dadurch gekennzeichnet, dass mindestens ein Schichtsystem, vom Substrat her betrachtet, wie folgt aufgebaut ist:

- eine Indium-Zinnoxidschicht,

- eine Schicht mit Niedrigbrechungsindex, vorzugsweise aus Siliziumoxid,

- eine Indium-Zinnoxidschicht,

- weitere Schichten.

19. Substrat nach Anspruch 18, dadurch gekennzeichnet, dass die weiteren Schichten durch das Schichtsystem nach Anspruch 1 gebildet sind.

20. Substrat nach einem der Ansprüche 1 bis 19, dadurch gekennzeichnet, dass mindestens das eine Schichtsystem, betrachtet ausgehend vom Substrat, wie folgt aufgebaut ist:

- 38nm HfON,

- 14nm HfN,

- 43nm HfON,

- 182nm $SiO_2$,

- 95nm HfON,

- 81nm $SiO_2$.

21. Substrat nach einem der Ansprüche 1 bis 20, dadurch gekennzeichnet, dass das mindestens eine Schichtsystem, vom Substrat her betrachtet, wie folgt aufgebaut ist:

- 13nm Indium-Zinnoxid,

- 40nm $SiO_2$,

- 137nm Indium-Zinnoxid,

- 199nm $SiO_2$,

- 97nm HfON,

- 98nm $SiO_2$.

22. Substrat nach einem der Ansprüche 1 bis 21, dadurch gekennzeichnet, dass beidseits des Substrates gleiche Schichtsysteme vorgesehen sind.

23. Substrat nach einem der Ansprüche 1 bis 22, dadurch gekennzeichnet, dass als Oxinitrid dasjenige des Hafniums eingesetzt ist, vorzugsweise in der Form $HfO_xN_y$ mit $3/2 \leq x/y \leq 3$ .

24. Substrat nach Anspruch 23, dadurch gekennzeichnet, dass gilt: $3/2 \leq x/y \leq 2$ , vorzugsweise $x/y \simeq$ ca. 1,7 .

25. Substrat nach einem der Ansprüche 23 oder 24, dadurch gekennzeichnet, dass der Brechungsindex des Hafnium-Oxinitrides 2,5 bis 2,8 bei Licht von 400nm beträgt.

26. Substrat nach einem der Ansprüche 23 bis 25, dadurch gekennzeichnet, dass die Extinktionskonstante k des Hafnium-Oxinitrides höchstens 0,02, vorzugsweise höchstens 0,01, beträgt.

27. Substrat nach einem der Ansprüche 23 bis 26, dadurch gekennzeichnet, dass mindestens eine Hafnium-Nitridschicht vorgesehen ist.

**28.** Substrat nach einem der Ansprüche 1 bis 27, dadurch gekennzeichnet, dass mindestens die Oxinitridschicht durch ein reaktives Abscheidungsverfahren hergestellt ist, vorzugsweise durch reaktives Ionenplattieren oder reaktives Sputtern.

**29.** Verwendung des beschichteten Substrates nach einem der Ansprüche 1 bis 28 für Durchsichtbereiche an Scheiben, vorzugsweise für Autoscheiben, insbesondere für Autowindschutzscheiben.

**30.** Verfahren zur Herstellung der Oxinitridschicht am Substrat nach einem der Ansprüche 1 bis 28 mittels eines reaktiven Abscheidungsprozesses, bei dem mindestens Sauerstoff und Stickstoff in vorgegebenem Verhältnis mit dem Metall in einer Reaktionskammer zur Reaktion gebracht werden und auf dem Werkstück die Schicht aus dem Reaktionsprodukt aufgebracht wird, dadurch gekennzeichnet, dass die beiden Gase im vorgegebenen Verhältnis einem Behältnis zugeführt werden, das Behältnis während einer Zeitspanne sich selbst überlassen wird und erst dann mit der Reaktionskammer zur Prozessdurchführung verbunden wird.

**31.** Verfahren nach Anspruch 30, dadurch gekennzeichnet, dass die Zeitspanne mindestens 12 Stunden beträgt.

**32.** Verfahren nach einem der Ansprüche 30 oder 31 für die Herstellung einer Hafnium-Oxinitridschicht mittels einer Ionenplattieranlage, dadurch gekennzeichnet, dass

- in der Anlage ein Argondruck von $3 \cdot 10^{-4}$mbar aufrechterhalten wird,

- in der Anlage ein Partialdruck des Sauerstoff-Stickstoffgemisches von $5 \cdot 10^{-4}$mbar erstellt wird,

- das Sauerstoff-Stickstoffgemisch zu 22Gew% Sauerstoff und 78Gew% Stickstoff erstellt wird und vorzugsweise eine Beschichtungsrate von 0,3nm/sec eingestellt wird.

**33.** Verfahren nach einem der Ansprüche 30 bis 32, dadurch gekennzeichnet, dass für die Erzeugung der Schicht sowie einer weiteren Schicht dasselbe Metall von einer Quelle freigesetzt wird und, ohne Prozessunterbruch, mindestens durch Aenderung des dem Prozess zugeführten Reaktionsgases die weitere Schicht aufgebracht wird.

**34.** Verfahren nach Anspruch 33, dadurch gekennzeichnet, dass als weitere Schicht eine Metall-Nitridschicht aufgebracht wird.

**35.** Anlage zur Ausführung des Verfahrens nach einem der Ansprüche 30 bis 34, umfassend eine Prozesskammer, eine Gaszuführanordnung, mindestens eine Reaktionsgaszuführanordnung für ein Reaktionsgasgemisch sowie Energiezuführmittel für die Reaktionsenergie in die Kammer, dadurch gekennzeichnet, dass die Reaktionsgaszuführanordnung ein Behältnis für das Reaktionsgasgemisch umfasst und eine Leitungsanordnung in die Kammer, mittels welcher das im Behältnis enthaltene Reaktionsgasgemisch in ungeändertem Mischungsverhältnis der Kammer zugeführt wird.

**36.** Anlage nach Anspruch 35, dadurch gekennzeichnet, dass es sich um eine Ionenplattieranlage handelt und die Mittel zur Reaktionsenergiezuführung mindestens einen Elektronenstrahlverdampfer sowie eine Entladungsstrecke umfassen.

**37.** Anlage nach Anspruch 35, dadurch gekennzeichnet, dass es sich um eine Sputteranlage handelt und die Mittel zur Reaktionsenergiezuführung mindestens ein Targetobjekt und eine Entladungsstrecke umfassen.

**38.** Hafnium-Oxinitrid als Schichtmaterial für ein beschichtetes Substrat nach einem der Ansprüche 1 bis 28, dadurch gekennzeichnet, dass sein Brechungsindex zwischen 2,6 und 2,8 liegt und sein Extinktionskoeffizient k höchstens 0,02 beträgt, dies bei Licht von 400nm.

**39.** Hafnium-Oxinitrid nach Anspruch 38, dadurch gekennzeichnet, dass der Extinktionskoeffizient k höchstens 0,01 beträgt.

**40.** Hafnium-Oxinitrid nach einem der Ansprüche 38 oder 39, dadurch gekennzeichnet, dass dies bei Licht im ganzen Bereich 400nm bis 1000nm gilt.

**41.** Hafnium-Oxinitrid nach einem der Ansprüche 38 bis 40, dadurch gekennzeichnet, dass es in der Form $HfO_xN_y$ folgende x/y-Verhältnisse aufweist:

$$1,5 \leq x/y \leq 3,$$

vorzugsweise

$$1,5 \leq x/y \leq 2,$$

vorzugsweise

$$1,6 \leq x/y \leq 1,8, \text{ insbesondere } x/y \simeq 1,7.$$

## Claims

1. Coated transparent substrate characterised in that an at least two-layer transparent metal-layer-free coating system is applied at least to one substrate side with at least one layer of the oxinitride of hafnium, zirconium, tantalum or titanium to reduce the solar radiation transmission ($T_{SUN}$) and to reduce the reflection ($R_{vis}$) of visible light.

2. Substrate according to Claim 1, characterised in that the oxinitride layer has a thickness of at least 30 nm, preferably at least 50 nm.

3. Substrate according to Claim 2, characterised in that the oxinitride layer has a thickness of at least 70 nm, preferably at least 90 nm.

4. Substrate according to any of Claims 1 to 3, characterised in that on the second substrate side is applied an at least two-layer coating system with at least one layer of an oxinitride of hafnium, zirconium, tantalum or titanium.

5. Substrate according to any of Claims 1 to 4, characterised in that at least on one substrate side, the coating system has at least one nitride layer of hafnium, zirconium, tantalum or titanium or at least one indium tin oxide layer.

6. Substrate according to Claim 5, characterised in that the nitride is of the same metal of which the oxinitride is formed.

7. Substrate according to Claim 6, characterised in that the nitride and oxinitride layers follow each other directly.

8. Substrate according to any of Claims 1 to 7, characterised in that a layer of oxinitride forms the second to outside system layer.

9. Substrate according to any of Claims 1 to 8, characterised in that its transmittance is at least 70%, preferably at least 75%, in the essential parts of the visible light range.

10. Substrate according to any of Claims 1 to 9, characterised in that up to angles of incidence of at least 60°, preferably at least 65°, the reflectance at least in essential parts of the visible light range is reduced in comparison with that of the uncoated substrate.

11. Substrate according to any of Claims 1 to 9, characterised in that at least in the spectral range of 520 nm to 620 nm and at least on one side the reflectance is at most 18%, preferably at most 15%, preferably up to angles of incidence of at least 60°, preferably at least 65°.

12. Substrate according to any of Claims 1 to 11, characterised in that the transmittance at least in the spectral range from 450 nm to 600 nm is at least 70%, preferably at least 75%.

13. Substrate according to any of Claims 1 to 12, characterised in that the refractive index of the oxinitride at least of one of the layers is 2.5 to 3, preferably 2.6 to 2.8, for light of 400 nm, with preferably the extinction constant k at most 0.02, preferably at most 0.01.

14. Substrate according to any of Claims 1 to 13, characterised in that the substrate is glass.

15. Substrate according to any of Claims 1 to 14, characterised in that at least one layer system consists of a sequence of hafnium oxinitride and silicon oxide, preferably as follows viewed from the substrate:

    - 8 nm HfON

- 42 nm $SiO_2$
- 103 nm HfON
- 193 nm $SiO_2$
- 98 nm HfON
- 95 nm $SiO_2$.

16. Substrate according to any Claims 1 to 15, characterised in that at least one layer system is constructed as follows viewed from the substrate:

- a layer of oxinitride of hafnium, zirconium, tantalum or titanium
- a nitride layer preferably of the same metal
- an oxinitride layer preferably of the same metal
- other layers.

17. Substrate according to Claim 16, characterised in that the further layers are formed by a layer system according to Claim 1.

18. Substrate according to any of Claims 1 to 17, characterised in that at least one layer system is constructed as follows viewed from the substrate:

- a layer of indium tin oxide
- a layer with low refractive index, preferably of silicon oxide
- a layer of indium tin oxide
- other layers.

19. Substrate according to Claim 18, characterised in that the further layers are formed by the layer system according to Claim 1.

20. Substrate according to any of Claims 1 to 19, characterised in that at least one layer system is constructed as follows viewed from the substrate:

- 38 nm HfON
- 14 nm HfN
- 43 nm HfON
- 182 nm $SiO_2$
- 95 nm HfON
- 81 nm $SiO_2$.

21. Substrate according to any of Claims 1 to 20, characterised in that at least one layer system is constructed as follows viewed from the substrate:

- 13 nm indium tin oxide
- 40 nm $SiO_2$
- 137 nm indium tin oxide
- 199 nm $SiO_2$
- 97 nm HfON
- 98 nm $SiO_2$.

22. Substrate according to any of Claims 1 to 21, characterised in that the same coating system is applied to both sides of the substrate.

23. Substrate according to any of Claims 1 to 22, characterised in that the oxinitride used is that of hafnium, preferably in the form $HfO_xN_y$ with $3/2 \leq x/y \leq 3$ .

24. Substrate according to Claim 23, characterised in that $3/2 \leq x/y \leq 2$ , preferably $x/y \approx$ approx. $1.7$ .

25. Substrate according to any of Claims 23 or 24, characterised in that the refractive index of the hafnium oxinitride is 2.5 to 2.8 at light of 400 nm.

26. Substrate according to any of Claims 23 to 25, characterised in that the extinction constant k of the hafnium oxinitride is at most 0.02, preferably at most 0.01.

27. Substrate according to any of Claims 23 to 26, characterised in that at least one hafnium nitride layer is present.

28. Substrate according to any of Claims 1 to 27, characterised in that at least the oxinitride layer is produced by a reactive deposition process, preferably by reactive ion plating or reactive sputtering.

29. Use of the coated substrate according to any of Claims 1 to 28 for transparent areas on windows, preferably for car windows, in particular for car windscreens.

30. Process for the production of the oxinitride layer on the substrate according to any of Claims 1 to 28 by means of a reactive deposition process in which at least oxygen and nitrogen in the specified ratio are brought to reaction with the metal in a reaction chamber and the coating is applied to the work piece from the reaction product, characterised in that the two gases are supplied to a container in a specific ratio, the container is allowed to stand for a time and only then connected to the reaction chamber for performance of the process.

31. Process according to Claim 30, characterised in that time span is at least 12 hours.

32. Process according to any of Claims 30 or 31 for the production of a hafnium oxinitride layer by means of an ion plating system, characterised in that

- an argon pressure of $3 . 10^{-4}$ mbar is maintained in the system
- a partial pressure of the oxygen-nitrogen mixture of $5 . 10^{-4}$ mbar is produced in the system
- the oxygen-nitrogen mixture is produced at 22w% oxygen and 78w% nitrogen and preferably set to a coating rate of 0.3 nm/sec.

33. Process according to any of Claims 30 to 32, characterised in that the same metal is released from a source for generation of the layer and of a further layer and without process interruption the further layer is applied at least by changing the reaction gas supplied to the process.

34. Process according to Claim 33, characterised in that a metal nitride layer is applied as a further layer.

35. Device for performance of the process according to any of Claims 30 to 34, comprising a process chamber, a gas supply arrangement, at least one reaction gas supply arrangement for a reaction gas mixture and energy supply means for the reaction energy in the chamber, characterised in that the reaction gas supply arrangement comprises a container for the reaction gas mixture and a line arrangement into the chamber by means of which the reaction gas mixture obtained in the container is supplied to the chamber in unchanged mix ratio.

36. Device according to Claim 35, characterised in that this is an ion plating device and the means for reaction energy supply comprise at least one electron beam vaporiser and a discharge path.

37. Device according to Claim 35, characterised in that this is a sputtering device and the means for reaction energy supply comprise at least one target object and a discharge path.

38. Hafnium oxinitride as the coating material for a coated substrate according to any of Claims 1 to 28, characterised in that its refractive index is between 2.6 and 2.8 and its extinction co-efficient k at most 0.02 at light of 400 nm.

39. Hafnium oxinitride according to Claim 38, characterised in that the extinction co-efficient k is at most 0.01.

40. Hafnium oxinitride according to any of Claims 38 or 39 characterised in that this applies to light over the entire range from 400 nm to 1000 nm.

41. Hafnium oxinitride according to any of Claims 38 to 40, characterised in that this in the form $HfO_xN_y$ has the following x/y ratios:

$$1.5 \leq x/y \leq 3$$

preferably

$$1.5 \leq x/y \leq 2$$

preferably

$$1.6 \leq x/y \leq 1.8, \text{ in particular } x/y \approx 1.7.$$

## Revendications

1. Substrat enduit transparent, caractérisé en ce qu'au moins sur l'une des faces du substrat est appliqué un système de couches, au moins bi-couche, transparent, sans couche métallique, ayant au moins une couche d'oxynitrure de hafnium, de zirconium, de tantale ou de titane, pour réduire la transmission du rayonnement solaire ($T_{SOLEIL}$) et pour réduire la réflexion ($R_{VIS}$) de la lumière visible.

2. Substrat selon la revendication 1, caractérisé en ce que la couche d'oxynitrure a une épaisseur d'au moins 30 nm et de préférence d'au moins 50 nm.

3. Substrat selon la revendication 2, caractérisé en ce que la couche d'oxynitrure a une épaisseur d'au moins 70 nm et de préférence d'au moins 90 nm.

4. Substrat selon l'une des revendications 1 à 3, caractérisé en ce qu'on applique sur la deuxième face du substrat un système de couches, au moins bi-couche, comportant au moins une couche d'oxynitrure de hafnium, de zirconium, de tantale ou de titane.

5. Substrat selon l'une des revendications 1 à 4, caractérisé en ce qu'au moins sur une face du substrat, le système de couches comporte au moins une couche de nitrure de hafnium, de zirconium, de tantale ou de titane, ou au moins une couche d'oxyde d'indium et d'étain.

6. Substrat selon la revendication 5, caractérisé en ce que le nitrure est le nitrure du même métal que celui dont est formé l'oxynitrure.

7. Substrat selon la revendication 6, caractérisé en ce que les couches de nitrure et d'oxynitrure se suivent directement.

8. Substrat selon l'une des revendications 1 à 7, caractérisé en ce qu'une couche constituée de l'oxynitrure forme la couche du système qui est la deuxième à partir de l'extérieur.

9. Substrat selon l'une des revendications 1 à 8, caractérisé en ce que sa transmission, au moins dans les parties principales du spectre de la lumière visible, est d'au moins 70 %, et de préférence d'au moins 75 %.

10. Substrat selon l'une des revendications 1 à 9, caractérisé en ce que, jusqu'à des angles d'incidence d'au moins 60°, de préférence d'au moins 65°, la réflexion, au moins dans des parties principales du spectre de la lumière visible, est réduite par rapport à la réflexion des parties du substrat non enduit.

11. Substrat selon l'une des revendications 1 à 9, caractérisé en ce que, au moins dans la zone spectrale de 520 à 620 nm, et au moins sur une face, la réflexion est au plus de 18 %, et de préférence d'au plus 15 %, et ce de préférence jusqu'à des angles d'incidence d'au moins 60°, de préférence d'au moins 65°.

12. Substrat selon l'une des revendications 1 à 11, caractérisé en ce que la transmission, au moins dans la zone spectrale de 450 à 600 nm, est d'au moins 70 % et de préférence d'au moins 75 %.

13. Substrat selon l'une des revendications 1 à 12, caractérisé en ce que l'indice de réfraction de l'oxynitrure d'au moins l'une des couches est de 2,5 à 3 et de préférence de 2,6 à 2,8, pour une lumière de 400 nm, la constante d'extinction k étant alors de préférence au plus égale à 0,02, et de préférence au plus égale à 0,01.

14. Substrat selon l'une des revendications 1 à 13, caractérisé en ce que le substrat est du verre.

15. Substrat selon l'une des revendications 1 à 14, caractérisé en ce qu'au moins un système de couches est constitué d'une succession d'oxynitrure de hafnium et d'oxyde de silicium, de préférence, en regardant à partir du substrat, comme suit :

- 8 nm de HfON,
- 42 nm de $SiO_2$,
- 103 nm de HfON,
- 193 nm de $SiO_2$,
- 98 nm de HfON,
- 95 nm de $SiO_2$.

16. Substrat selon l'une des revendications 1 à 15, caractérisé en ce qu'au moins un système de couches, considéré à partir du substrat, a la structure suivante :

- une couche d'oxynitrure de hafnium, de zirconium, de tantale ou de titane,
- une couche de nitrure, de préférence du même métal,
- une couche d'oxynitrure, de préférence du même métal,
- d'autres couches.

17. Substrat selon la revendication 16, caractérisé en ce que les autres couches sont formées d'un système de couches selon la revendication 1.

18. Substrat selon l'une des revendications 1 à 17, caractérisé en ce qu'au moins un système de couches, considéré à partir du substrat, a la structure suivante :

- une couche d'oxyde d'indium et d'étain,
- une couche à faible indice de réfraction, de préférence d'oxyde de silicium,
- une couche d'oxyde d'indium et d'étain,
- d'autres couches.

19. Substrat selon la revendication 18, caractérisé en ce que les autres couches sont formées par le système de couches selon la revendication 1.

20. Substrat selon l'une des revendications 1 à 19, caractérisé en ce qu'au moins un système de couches, considéré à partir du substrat, a la structure suivante :

- 38 nm de HfON,
- 14 nm de HfN,
- 43 nm de HfON,
- 182 nm de $SiO_2$,
- 95 nm de HfON,
- 81 nm de $SiO_2$.

21. Substrat selon l'une des revendications 1 à 20, caractérisé en ce qu'au moins un système de couches, considéré à partir du substrat, a la structure suivante :

- 13 nm d'oxyde d'indium et d'étain,
- 40 nm de $SiO_2$,
- 137 nm d'oxyde d'indium et d'étain,
- 199 nm de $SiO_2$,
- 97 nm de HfON,
- 98 nm de $SiO_2$.

22. Substrat selon l'une des revendications 1 à 21, caractérisé en ce qu'on prévoit des systèmes de couches identiques sur les deux faces du substrat.

23. Substrat selon l'une des revendications 1 à 22, caractérisé en ce qu'on utilise comme oxynitrure l'oxynitrure de hafnium, de préférence sous la forme $HfO_xN_y$, avec $3/2 \leq x/y \leq 3$ .

24. Substrat selon la revendication 23, caractérisé en ce que l'on a $3/2 \leq x/y \leq 2$ , de préférence $x/y$ = environ 1,7 .

25. Substrat selon l'une des revendications 23 et 24, caractérisé en ce que l'indice de réfraction de l'oxynitrure de hafnium est de 2,5 à 2,8 pour une lumière de 400 nm.

**26.** Substrat selon l'une des revendications 23 à 25, caractérisé en ce que la constante d'extinction k de l'oxynitrure de hafnium est au plus de 0,02 et de préférence au plus de 0,01.

**27.** Substrat selon l'une des revendications 23 à 26, caractérisé en ce qu'on prévoit au moins une couche de nitrure de hafnium.

**28.** Substrat selon l'une des revendications 1 à 27, caractérisé en ce qu'on fabrique au moins la couche d'oxynitrure par un procédé de dépôt réactif, de préférence par plaquage ionique réactif ou par pulvérisation cathodique réactive.

**29.** Utilisation du substrat enduit selon l'une des revendications 1 à 28, pour des zones transparentes de vitres, de préférence pour vitres d'automobiles, en particulier de pare-brise pour automobiles.

**30.** Procédé de fabrication de la couche d'oxynitrure sur le substrat selon l'une des revendications 1 à 28, à l'aide d'un procédé de dépôt réactif, dans lequel on fait réagir au moins de l'oxygène et de l'azote, selon une proportion prédéfinie, avec le métal dans une chambre de réaction, et on applique sur la pièce à traiter la couche en le produit de la réaction, caractérisé en ce que les deux gaz, selon une proportion prédéfinie, sont introduits dans un récipient, le récipient est abandonné à lui-même pendant un certain laps de temps, et ce n'est qu'ensuite qu'on le relie à la chambre de réaction pour permettre la mise en oeuvre du procédé.

**31.** Procédé selon la revendication 30, caractérisé en ce que le laps de temps est d'au moins 12 heures.

**32.** Procédé selon l'une des revendications 30 et 31, pour fabriquer une couche d'oxynitrure de hafnium, à l'aide d'une installation de placage ionique, caractérisé en ce que:

- on maintient dans l'installation une pression d'argon de $3 \times 10^{-4}$ mbar,
- on établit dans l'installation une pression partielle du mélange oxygène-azote de $5 \times 10^{-4}$ mbar,
- on ajuste le mélange oxygène-azote à 22 % en poids d'oxygène et 78 % en poids d'azote, et de préférence on ajuste la vitesse d'enduction à 0,3 nm/sec.

**33.** Procédé selon l'une des revendications 30 à 32, caractérisé en ce que, pour produire la couche, ainsi qu'une autre couche, on libère d'une source le même métal, et, sans interruption des opérations, on applique l'autre couche au moins par un changement du gaz réactionnel introduit dans le procédé.

**34.** Procédé selon la revendication 33, caractérisé en ce qu'on applique comme autre couche une couche de nitrure métallique.

**35.** Installation pour mettre en oeuvre le procédé selon l'une des revendications 30 à 34, comportant une chambre de réaction, un dispositif d'amenée de gaz, au moins un dispositif d'amenée de gaz réactionnel, destiné à un mélange de gaz réactionnel, ainsi qu'un moyen d'amenée d'énergie pour l'énergie de réaction dans la chambre, caractérisée en ce que le dispositif d'amenée de gaz réactionnel comporte un récipient pour mélange de gaz réactionnel, ainsi qu'une canalisation allant dans la chambre, à l'aide de laquelle le mélange de gaz réactionnel contenu dans le récipient est envoyé dans la chambre, le rapport de mélange restant inchangé.

**36.** Installation selon la revendication 35, caractérisée en ce qu'il s'agit d'une installation de placage ionique, et en ce que le moyen d'amenée de l'énergie de réaction comporte au moins un vaporisateur à jet d'électrons, ainsi qu'une zone de décharge.

**37.** Installation selon la revendication 35, caractérisée en ce qu'il s'agit d'une installation de pulvérisation cathodique, et en ce que les moyens d'amenée de l'énergie de réaction comportent au moins un objet cible et une zone de décharge.

**38.** Oxynitrure de hafnium, servant de matériau de couche pour un substrat enduit selon l'une des revendications 1 à 28, caractérisé en ce que son indice de réfraction est compris entre 2,6 et 2,8, son coefficient d'extinction k étant au plus de 0,02, et ce pour une lumière de 400 nm.

**39.** Oxynitrure de hafnium selon la revendication 38, caractérisé en ce que le coefficient d'extinction k est au plus égal à 0,01.

**40.** Oxynitrure de hafnium selon l'une des revendications 38 et 39, caractérisé en ce que ce qui y est dit est valable pour une lumière comprise dans la totalité de la plage de 400 à 1000 nm.

**41.** Oxynitrure de hafnium selon l'une des revendications 38 à 40, caractérisé en ce que, sous la forme $HfO_xN_y$, il présente un rapport x/y satisfaisant aux conditions suivantes:

$$1,5 \leqq x/y \leqq 3,$$

de préférence

$$1,5 \leqq x/y \leqq 2,$$

de préférence

$$1,6 \leqq x/y \leqq 1,8, \text{ en particulier } x/y = \text{environ } 1,7.$$

$S_1$

$S_2$

4

1

7

9

5

3

11

13

15

17

23

19

I

N_2

$O_2$
$N_2$

21

FIG.1

23

20A

20

25

20B

27

24

FIG.2

Innen

23 {

24'

26

20

24

Aussen

FIG.3

Innen

23 {

24'

32
30 } 26
28

20

B

24

Aussen

FIG.4

Innen

23 {

24'

38
36 } 26
34

20

24

Aussen

FIG.5

FIG.6

AUSSEN                    INNEN

FIG. 7.1

AUSSEN                              INNEN

FIG. 8.1
von Innen

FIG.9.1

FIG.7. 2

24 ← 23 →

20

DIEL                    ITO

AUSSEN                  INNEN

FIG.8.2
von Aussen

% REFLECTANCE

WAVELENGTH (n m)

FIG.9.2
von Aussen

% TRANSMITTANCE

WAVELENGTH (n m)

FIG.7.3

DIEL          DIEL

FIG.8.3
von Innen
= von Aussen

FIG.9.3
von Innen
= von Aussen

FIG.10.3
von Innen
= von Aussen

FIG.12.3

FIG.7.4

Ⓐ

Ⓑ

24 ———

——23

20

FIG.7.5

FIG. 10.1
von Aussen

FIG. 11.1
von Aussen

FIG. 12 .1

FIG.10.2.1
von Innen

FIG.10.2.2
von Aussen

FIG.12.2